# EUROPEAN PATENT APPLICATION

(11) **EP 2 479 780 A1**
(43) Date of publication of application: **25.07.2012**
(21) Application number: 10817040.8
(22) Date of filing: 30.08.2010
(51) Int. Cl.: H01L 21/205, C23C 16/50, H01L 31/04

(54) **FILM FORMATION APPARATUS**

(30) Priority: 17.09.2009 JP 2009215851; 16.07.2010 JP 2010161955
(71) Applicant: Tokyo Electron Limited, Tokyo 107-6325 (JP)
(72) Inventor: SAWADA Ikuo, Nirasaki-shi Yamanashi 407-0192 (JP); KANG Song Yun, Nirasaki-shi Yamanashi 407-0192 (JP); MATSUKUMA Masaaki, Nirasaki-shi Yamanashi 407-0192 (JP); KASAI Shigeru, Nirasaki-shi Yamanashi 407-0192 (JP); MORISHIMA Masato, Nirasaki-shi Yamanashi 407-0192 (JP)
(74) Representative: HOFFMANN EITLE
(86) International application number: PCT/JP2010/064707
(87) International publication number: WO 2011/033927

(57) **Abstract**

Disclosed is a film formation apparatus (1a) that forms a thin film upon a substrate (S), wherein partitions (41) separate the space above the substrate (S) into a plasma generation space (401) and an exhaust space (402) and extend downward from the ceiling of the processing container (10) to form an opening between the substrate (S) and the bottom end of the partitions, in which gas flows from the plasma generation space (401) to the exhaust space (402). An activating mechanism (42, 43) generates plasma by activating a first reactant gas that has been supplied to the plasma generation space (401). A second reactant gas supply section (411, 412) supplies a second reactant gas to the bottom of the plasma generation space (401), and an evacuation opening (23) evacuates the exhaust space (402) from a position that is higher than the bottom end of the partitions (41).

## Description

### Field of the Invention

The present invention relates to a technology for forming a thin film of, e.g., silicon on a large-area substrate to be used for solar cells or the like.

### Background of the Invention

Recently, extensive studies have been conducted on thin-film silicon solar cells which consume a small amount of silicon and are relatively easily formed in a large area compared to bulk-type crystalline silicon solar cells. For example, tandem thin-film silicon solar cells (hereinafter, simply referred to as solar cells) are configured to enhance light energy conversion efficiency by laminating an amorphous silicon film on an upper surface of a microcrystalline silicon film such that each film absorbs light having a different wavelength range.

In a case where an amorphous silicon film (a-Si film) or a microcrystalline silicon film (µc-Si film) is formed on a large-area substrate, e.g., a chemical vapor deposition (CVD) method or the like is used such that a monosilane (SiH₄) gas is reacted with a hydrogen (H₂) gas in a vacuum atmosphere to deposit silicon on the substrate. The a-Si film or µc-Si film may be selectively formed, e.g., by adjusting a partial pressure ratio of SiH₄ gas to H₂ gas.

In a manufacturing process of solar cells, in order that film formation can be achieved on, e.g., a glass substrate with low heat resistance, there is employed a relatively low temperature process such as plasma CVD in which a high frequency power, microwave or the like is applied to convert SiH₄ or H₂ into a plasma and generated active species are reacted with each other to obtain an a-Si film or µc-Si film. In the plasma CVD, although various active species are generated from SiH₄ or H₂, as well known in the art, dominant active species for growth of the a-Si, film or µc-Si film are SiH₃.

Meanwhile, active species other than SiH₃, e.g., Si, SiH and SiH₂ are incorporated in the film while having dangling bonds, thereby resulting in defects that cause a reduction in film quality. Further, the active species may be polymerized to generate high-order silane such as SiₙH₂ₙ₊₂ (n = 2, 3, 4···). Also when the high-order silane is incorporated in the film, or when the high-order silane is further grown and incorporated in a state of fine particles into the film, it may cause defects in the Si film.

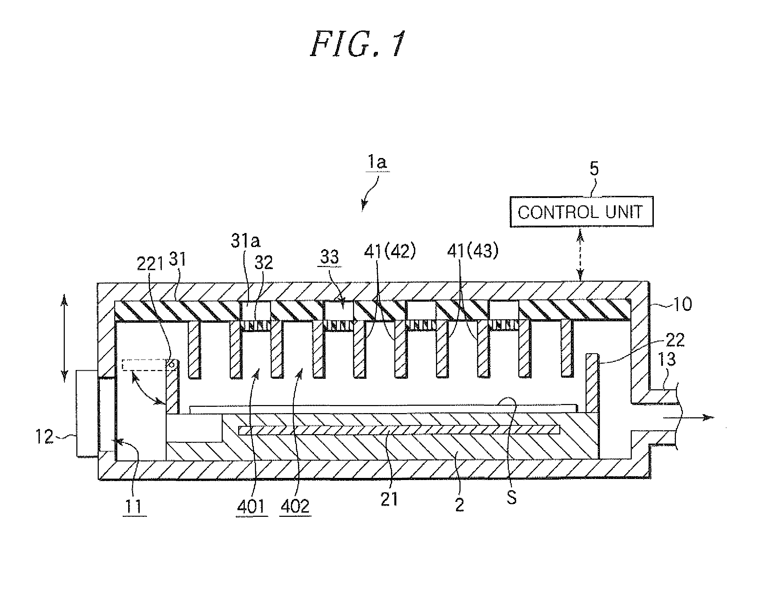

To solve these problems, e.g., Japanese Patent Laid-open Application No. 2004-289026 (Paragraphs [0012] to [0014], [0018] and [0019], and FIG. 1) discloses a CVD method wherein a gas obtained by adding SiF₄ to the above-described SiH₄ or H₂ is supplied to a surface of a substrate, and the gas is converted into a plasma by a microwave supplied from a waveguide. In this CVD method, negative ions (F⁻) and positive ions (H⁺, H₃⁺, SiH₃⁺) are generated from the gas, and these ions are reacted with each other, so that a µc-Si film with good quality is formed by using heat of reaction generated in the vicinity of the surface of the substrate. In this case, since a sheath (charge layer) having negative charges is formed on the surface of the substrate by applying a microwave, negative ions (F⁻) do not reach the substrate during film formation. In this technique, since film formation is performed by using heat of reaction generated when positive ions are combined with negative ions, a relatively low temperature process may be used. Meanwhile, a substrate of solar cells becomes increasingly large, and for example, a gas residence time until a gas supplied to the vicinity of the center of the substrate reaches a peripheral portion of the substrate tends to be longer.

Even when the substrate is large and a gas residence time until a gas supplied to the vicinity of the center of the substrate reaches a peripheral portion of the substrate is long, for example, in the area immediately after a fresh gas is supplied, the reaction is allowed to proceed as designed, and a Si film with good quality may be formed. However, since various active species are generated from the gas that has been converted into a plasma by using a microwave, if the gas residence time on the substrate becomes long, these active species are gradually reacted with each other to generate high-order silane or fine particles and the like, and they may be incorporated into the film to thereby cause a reduction in film quality of the Si film.

### Summary of the Invention

The present invention provides a film formation apparatus capable of forming a film with good quality even on a large-area substrate.

In accordance with an embodiment of the present invention, there is provided a film formation apparatus for forming a thin film on a substrate by reacting plural types of reactant gases in an airtight processing container, including: a mounting table which is placed in the processing container and on which the substrate is mounted; a partition which extends downward from a ceiling of the processing container and is provided to laterally divide a space above the substrate mounted on the mounting table into a plasma generation space and an exhaust space, an opening being formed between a bottom end of the partition and the substrate mounted on the mounting table to flow a gas from the plasma generation space to the exhaust space; a first reactant gas supply section which supplies a first reactant gas to the plasma generation space; an activating mechanism which activates the first reactant gas supplied to the plasma generation space to generate a plasma; a second reactant gas supply section which supplies a second reactant gas to a lower portion of the plasma generation space or a side lower than the plasma generation space such that the second reactant gas reacts with active species of the first reactant gas to form the thin film on the substrate; and a vacuum evacuation opening provided to evacuate the exhaust space.

In the film formation apparatus of the present invention, the vacuum evacuation opening may be formed at a position higher than the bottom end of the partition.

Further, in the film formation apparatus of the present invention, the activating mechanism may include: an anode electrode and a cathode electrode forming parallel electrodes for generating a capacitively coupled plasma in the plasma generation space; and a high frequency power supply unit which applies a high frequency power between the anode electrode and the cathode electrode. Further, the activating mechanism may include an antenna provided above the plasma generation space to generate an inductively coupled plasma or a microwave plasma.

Further, in the film formation apparatus of the present invention, the partition may be provided in plural number, and the plural partitions are provided in parallel to each other, and wherein plasma generation spaces and exhaust spaces are alternately arranged by the partitions. Further, the partitions linearly extend in a lateral direction.

In the case of having a configuration in which plasma generation spaces and exhaust spaces are alternately arranged by the partitions, the activating mechanism may include: an anode electrode and a cathode electrode which are provided at one and the other of each of the pairs of partitions facing each other with the plasma generation spaces interposed therebetween, and form parallel electrodes for generating a capacitively coupled plasma; and a high frequency power supply unit which applies a high frequency power between the anode electrode and the cathode electrode.

Further, similarly, in the case of having a configuration in which plasma generation spaces and exhaust spaces are alternately arranged by the partitions, the activating mechanism may include: electrodes provided at the respective partitions, the electrodes provided at each pair of the partitions opposite to each other being a pair of parallel electrodes for generating a capacitively coupled plasma in a plasma generation space between the opposite partitions; a high frequency power supply unit which applies a high frequency power between the pair of electrodes; and a connection switching unit for switching connection between the electrodes forming the parallel electrodes and a power terminal of the high frequency power supply unit such that positions of the plasma generation space and the exhaust space are replaced with each other at preset time intervals. The film formation apparatus may further include a gas supply switching section for switching a gas supply in synchronization with a switching operation of the connection switching unit such that the first reactant gas and the second reactant gas are supplied to the plasma generation space and are not supplied to the exhaust space.

In the film formation apparatus of the present invention, the partition may be formed in a cylindrical shape to surround the plasma generation space, and the partition having the cylindrical shape is provided in plural number to provide separated partitions, and wherein the activating mechanism includes an antenna unit provided above each plasma generation space to generate an inductively coupled plasma or a microwave plasma.

Further, in the film formation apparatus of the present invention, the vacuum evacuation opening may be formed on a sidewall of the processing container. Further, the first reactant gas may be a hydrogen gas and the second reactant gas is a silicon compound gas.

### Brief Description of the Drawings

FIG. 1 is a vertical section view showing a film formation apparatus of a first embodiment of the present invention.
FIG. 2 is a perspective view showing an external appearance of the film formation apparatus of the first embodiment of the present invention.
FIG. 3A is a plan view showing a state before a substrate is mounted in an example of a mounting table placed in the film formation apparatus of FIG. 1.
FIG. 3B is a plan view showing a state in which the substrate is mounted by a transfer arm in the example of the mounting table placed in the film formation apparatus of FIG. 1.
FIG. 3C is a plan view showing a state in which the substrate is mounted by a transfer arm in another example of the mounting table placed in the film formation apparatus of FIG. 1.
FIG. 4 is a partially cutaway perspective view showing an inner configuration of the film formation apparatus in accordance with the first embodiment of the present invention.
FIG. 5 is a partially cutaway perspective view showing a configuration of partitions provided in the film formation apparatus in accordance with the first embodiment of the present invention.
FIG. 6 schematically shows an arrangement state of plasma generation spaces and exhaust spaces provided in the film formation apparatus in accordance with the first embodiment of the present invention.
FIG. 7 is a vertical section view for explaining an action of the film formation apparatus in accordance with the first embodiment of the present invention.
FIG. 8 is a vertical section view showing a film formation apparatus in accordance with a second embodiment of the present invention.
FIG. 9 is a horizontal section view showing the film formation apparatus in accordance with the second embodiment of the present invention.
FIG. 10 is a perspective view showing an inner configuration of the film formation apparatus in accordance with the second embodiment of the present invention.
FIG. 11 schematically shows a modification example of the film formation apparatus in accordance with the second embodiment of the present invention.
FIG. 12 is a vertical section view showing a film formation apparatus in accordance with a third embodiment of the present invention.
FIG. 13 is a partially cutaway perspective view showing an inner configuration of the film formation apparatus in accordance with the third embodiment of the present invention.
FIG. 14 is a partially cutaway perspective view showing a configuration of partitions provided in the film formation apparatus in accordance with the third embodiment of the present invention.
FIG. 15 is a vertical section view showing a configuration of microwave antenna units provided in the film formation apparatus in accordance with the third embodiment of the present invention.
FIG. 16 is a vertical section view for explaining an action of the film formation apparatus in accordance with the third embodiment of the present invention.
FIG. 17 is a vertical section view showing a film formation apparatus in accordance with a fourth embodiment of the present invention.
FIG. 18 is a partially cutaway perspective view showing an inner configuration of the film formation apparatus in accordance with the fourth embodiment of the present invention.
FIG. 19 is a partially cutaway perspective view showing a configuration of partitions provided in the film formation apparatus in accordance with the fourth embodiment of the present invention.
FIG. 20 is a vertical section view for explaining an action of the film formation apparatus in accordance with the fourth embodiment of the present invention.
FIG. 21 is a partially cutaway perspective view showing a film formation apparatus in accordance with a fifth embodiment of the present invention.
FIG. 22 is a vertical section view showing the film formation apparatus in accordance with the fifth embodiment of the present invention.
FIG. 23A is a vertical section view for explaining an action of the film formation apparatus in accordance with the fifth embodiment of the present invention.
FIG. 23B is a vertical section view for explaining an action of the film formation apparatus in accordance with the fifth embodiment.
FIG. 24 is a vertical section view showing a modification example of the film formation apparatus in accordance with the fifth embodiment of the present invention.
FIG. 25 is a vertical section view showing another modification example of the film formation apparatus in accordance with the fifth embodiment of the present invention.

### Detailed Description of the Embodiments

Hereinafter, embodiments of the present invention will be described in detail with reference to the accompanying drawings.

### <First Embodiment>

A film formation apparatus of a first embodiment includes parallel electrodes as an activating mechanism, and forms a µc-Si film as a thin film by activating H₂ using a capacitively coupled plasma to react with SiH₄.

First, a configuration of the film formation apparatus of the first embodiment will be described with reference to FIGS. 1 to 6.

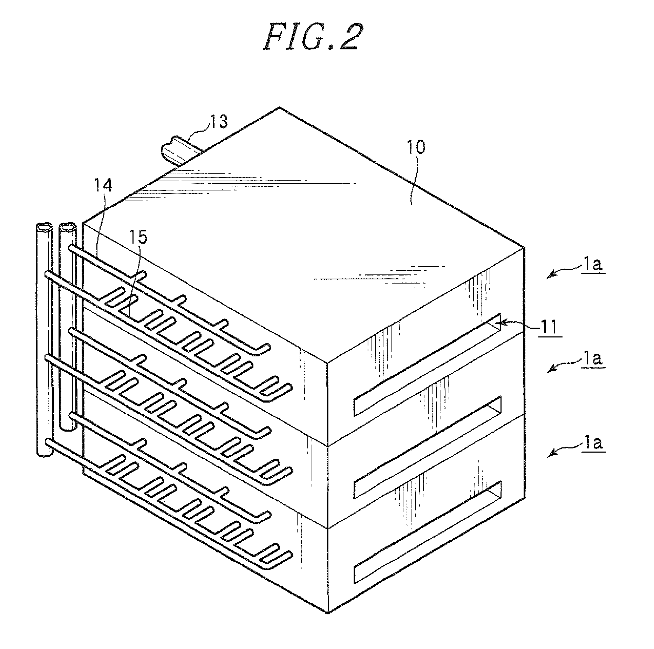

FIG. 1 is a vertical section view showing the film formation apparatus of the first embodiment. FIG. 2 is a perspective view showing an external appearance of the film formation apparatus of the first embodiment.

As shown in FIG. 1, the film formation apparatus 1a of this embodiment includes a processing container 10 that is a vacuum container, a mounting table 2 placed in the processing container 10 to mount a substrate S on which a film is formed, and a mechanism for supplying activated H₂ and SiH₄ to the surface of the substrate S mounted on the mounting table 2. The processing container 10 is configured as a flat container that can be sealed and is made of, e.g., metal. The processing container 10 has a size capable of accommodating a large-area glass substrate S of, e.g., 1100 mm X 1400 mm or more.

As shown in FIG. 2, the film formation apparatus 1a has upper and lower flat surfaces such that multiple film formation apparatuses 1a can be stacked vertically. PIG. 2 illustrates a case where, e.g., three film formation apparatuses 1a are stacked vertically. For example, in this case, a common preliminary vacuum chamber may be provided at the side of loading/unloading ports 11 of these film formation apparatuses 1a and a substrate transfer mechanism being movable vertically may be placed in the preliminary vacuum chamber to carry out loading/unloading of the substrate S while maintaining a vacuum state of each of the film formation apparatuses 1a.

In FIG. 1, reference numeral 11 denotes a loading/unloading port of the substrate S provided in the processing container 10, and reference numeral 12 denotes a gate valve for opening and closing the loading/unloading port 11. Further, an exhaust passage 13 is provided on, e.g., a sidewall of the processing container 10 to vacuum evacuate the processing container 10, and, e.g., a vacuum pump (not shown) is connected to the downstream side of the exhaust passage 13 such that an inner pressure of the processing container 10 can be adjusted, e.g., from 13.3 Pa (0.1 Torr) to 2.7 kPa (20 Torr).

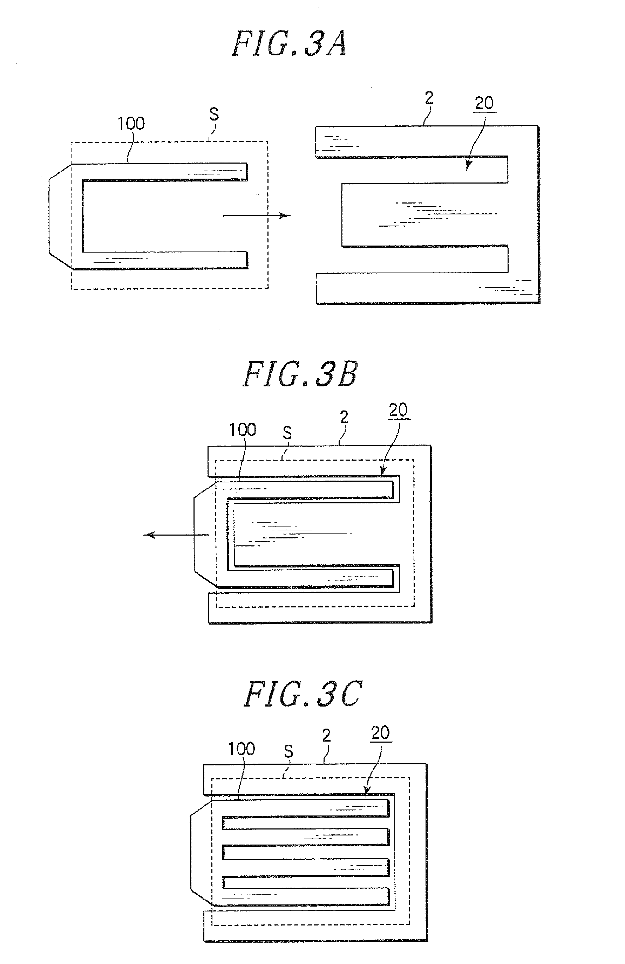

The mounting table 2 is placed on the bottom surface of the processing container 10. The large-area substrate S is mounted on the mounting table 2 such that film formation of a µc-Si film is carried out on the substrate S. The mounting table 2 includes, as shown in a plan view of FIG. 3A, a cutout portion 20 corresponding to a fork shape of a transfer arm 100 which is provided externally to transfer the substrate S. Accordingly, as shown in FIG. 3B, the transfer arm 100 holding the substrate S is moved to the position above the mounting table 2 and then moved out from the lower side of the mounting surface of the substrate S, thereby performing the transfer of the substrate S. As shown in FIGS. 3A and 3B, in the film formation apparatus 1a of this embodiment, the substrate S is loaded and unloaded from the short side of the substrate S.

As shown in FIG. 1, a temperature control part 21 consisting of, e.g., a resistance heating element is embedded in the mounting table 2, so that the substrate S can be controlled to a temperature of, e.g., 200°C to 300°C through the top surface of the mounting table 2. Without being limited to heating the substrate S, the temperature control part 21, e.g., employing a Peltier element or the like, may cool the substrate S under the process conditions so that the substrate S is adjusted to a predetermined temperature.

As described above, in the film formation apparatus 1a of this embodiment, since the temperature control of the substrate S is performed through the top surface of the mounting table 2, in order to increase a heat transfer area between the mounting table 2 and the substrate S, the transfer arm 100 is configured to have two prongs as shown in FIGS. 3A and 3B to reduce the area of the cutout portion 20. In contrast, in a case where the temperature control of the substrate S is not performed through the mounting table 2, for example, as shown in FIG. 3C, the number of prongs of the transfer arm 100 is increased such that a large-sized substrate S can be more stably transferred. The cutout portion 20 corresponding to the shape of the transfer arm 100 is provided in the mounting table 2 such that, e.g., three sides of the substrate S are supported from the mounting table 2.

In this case, in the film formation apparatus 1a of this embodiment, while SiH₃ required for growth of a µc-Si film is supplied in high concentration to the surface of the substrate S, active species such as Si, SiH and SiH₂ other than SiH₃, and materials such as high-order silane or fine particles of the high-order silane causing degradation of the quality of the µc-Si film are suppressed from being supplied to the surface of the substrate S, thereby obtaining the actions listed below.
(1) SiH₃ can be supplied in high concentration to the surface of the substrate S while suppressing generation of unnecessary active species by suppressing SiH₄ (corresponding to a second reactant gas) from being converted into a plasma and reacting SiH₄ with H radicals obtained by converting H₂ (corresponding to a first reactant gas) into a plasma.
(2) It is possible to suppress generation of unnecessary active species due to excessive reaction between SiH₄ and H radicals by rapidly discharging a gaseous mixture of SiH₄ and H radicals from the surface of the substrate S.

Hereinafter, various configurations provided in the film formation apparatus 1a to obtain the above actions will be described.

For example, as shown in FIGS. 1, 4 and 6, the film formation apparatus 1a includes, e.g., ten partitions 41 to divide the space above the substrate S mounted on the mounting table 2 in a transverse direction, e.g., from the loading/unloading port to the inner side. Further, for convenience of illustration, a case of providing ten partitions 41 is illustrated, but the number of the partitions 41 is not limited thereto. Each of the partitions 41 is configured as a straight flat plate made of, e.g., metal. For example, the length of the partition 41 in its width direction is longer than the short side of the substrate S. The partitions 41 are arranged in parallel to each other, e.g., at regular intervals such that the sides of the partitions 41 in the width direction are perpendicular to the long sides of the substrate S mounted on the mounting table 2 in a horizontal direction. Accordingly, a narrow and long space (corresponding to each of plasma generation spaces 401 and exhaust spaces 402 that will be described later) is formed between two adjacent partitions 41 to extend in a direction perpendicular to the long sides of the substrate S. Each of the partitions 41 is fixed to the ceiling of the processing container 10 through an insulating member 31.

Further, the partitions 41 are formed to extend downward from the ceiling so that an opening of, e.g., about 1 cm to 5 cm is formed between the surface of the substrate S mounted on the mounting table 2 and the bottom end of the partitions 41. Accordingly, respective spaces 401 and 402, each space being surrounded by two adjacent partitions 41, communicate with each other through the opening. Further, the opening is adjusted to have a height such that the partitions 41 do not interfere with a loading/unloading path of the substrate S.

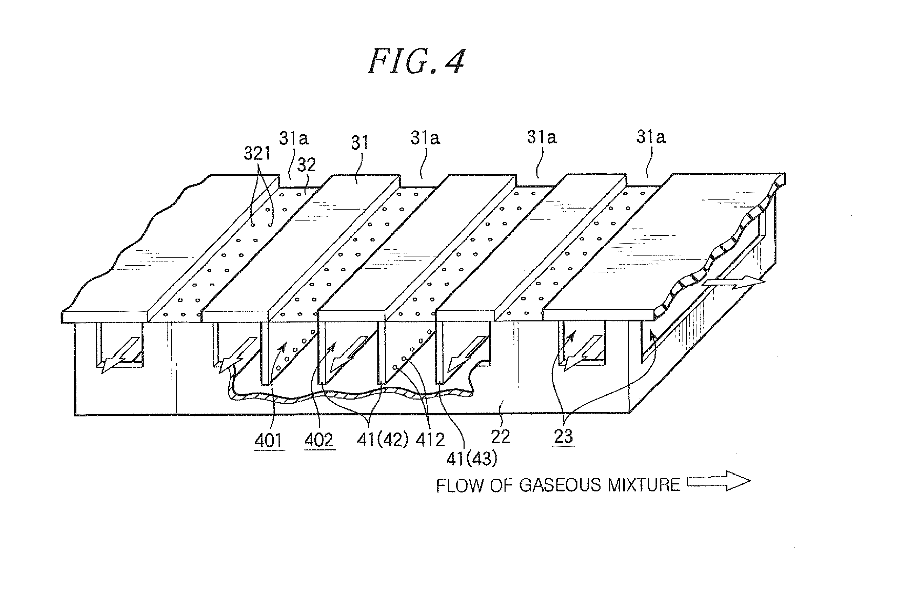

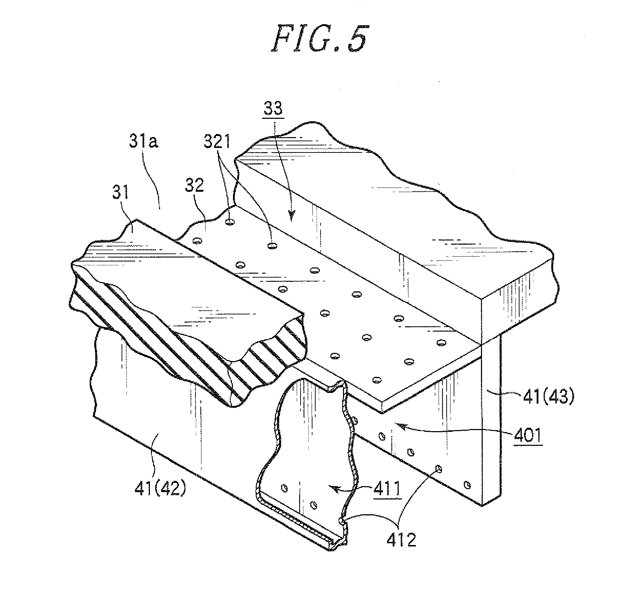

The insulating member 31 includes grooves 31a in portions between the second and third partitions 41, between the fourth and fifth partitions 41, between the sixth and seventh partitions 41, and between the eighth and ninth partitions 41 when counted from the loading/unloading port side. Each of the grooves 31a is formed in an extending direction of the plasma generation spaces 401 formed between the adjacent partitions 41 (in the direction perpendicular to the long sides of the substrate S). As shown in FIGS. 4 and 5, shower plates 32 formed of, e.g., an insulating material and having discharge holes 321 are arranged at the lower surfaces of the grooves 31a.

Spaces surrounded by the shower plates 32 and the grooves 31a formed in the insulating member 31 constitute first gas flow paths 33 for supplying H₂ serving as a first reactant gas to the plasma generation spaces 402 formed therebelow. As shown in FIG. 2, the first gas flow paths 33 are respectively connected to a first gas supply pipe 14 at the sidewall of the processing container 10, such that H₂ (containing argon (Ar) for forming a high-density plasma at a percentage of, e.g., 10%) can be supplied to the first gas flow paths 33 from a H₂ supply source (not shown) through the first gas supply pipe 14. Further, a flow rate controller (not shown) consisting of a mass flow controller or the like is provided in the first gas supply pipe 14, so that a total amount of H₂ supplied to the first gas flow paths 33 can be adjusted in a range of, e.g., 1000 cc/min to 100000 cc/min under standard conditions (25°C and 1 atm).

The discharge holes 321 of the shower plates 32 are provided to uniformly supply H₂ into the plasma generation spaces 401 formed below the first gas flow paths 33. The first gas flow paths 33, the shower plates 32 and the first gas supply pipe 14 correspond to a first reactant gas supply section of this embodiment.

Next, a SiH₄ supply system will be described. Each of the second to ninth partitions 41 has a cavity as shown in FIG. 5. The partitions 41 include discharge holes 412 opened toward the spaces 401 below the first gas flow paths 33. The discharge holes 412 are provided at lower end portions of the partitions 41 linearly along the bottom surfaces. The cavities in the partitions 41 constitute second gas flow paths 411 for supplying SiH₄ to lower end portions of the spaces 401 through the discharge holes 412.

As shown in FIG. 2, the second gas flow paths 411 are connected to a second gas supply pipe 15 at the sidewall of the processing container 10, such that SiH₄ can be supplied to second gas flow paths 411 from a SiH₄ supply source (not shown) through the second gas supply pipe 15. Further, a flow rate controller (not shown) consisting of a mass flow controller or the like is provided in the second gas supply pipe 15, so that a total amount of SiH₄ supplied to the second gas flow paths 411 can be adjusted in a range of, e.g., 20 cc/min to 2000 cc/min under standard conditions (25°C and 1 atm). Similarly to the discharge holes 321 of the shower plates 32, it is preferable that the discharge holes 412 on the side of the second gas flow paths 411 are provided to uniformly supply SiH₄. The second gas flow paths 411, the discharge holes 412 and the second gas supply pipe 15 correspond to a second reactant gas supply section of this embodiment.

As shown in FIGS. 1 and 4, a square tubular peripheral wall 22 is provided on the periphery of the top surface of the mounting table 2 to surround the substrate S mounted on the mounting table 2 and the circumference of the partitions 41. As shown in FIG. 4, the peripheral wall 22 extends vertically, e.g., from the top surface of the mounting table 2 to the ceiling of the processing container 10. Evacuation openings 23 serving as vacuum evacuation openings of this embodiment are cut out from four surfaces of front and rear surfaces and left and right surfaces when viewed from the loading/unloading port side.

As shown in FIG. 4, one evacuation opening 23 having a large width approximately equal to that of, e.g., the partitions 41 is cut out from each of the front and rear surfaces of the peripheral wall 22. Meanwhile, the evacuation openings 23 are cut out from the left and right surfaces of the peripheral wall 22 at positions corresponding to the spaces 402 formed between the first and second partitions 41, between the third and fourth partitions 41, between the fifth and sixth partitions 41, between the seventh and eighth partitions 41, and between the ninth and tenth partitions 41. All of the evacuation openings 23 formed on the four surfaces of front, rear, left and right surfaces of the peripheral wall 22 are formed at positions about 1 cm to 5 cm higher than the top surface of the mounting table 2, i.e., at positions higher than the bottom end of the partitions 41. In this case, the front surface of the peripheral wall 22 facing the loading/unloading port 11 is configured, as shown in FIG. 1, to be rotatable around a rotation axis 221 toward the loading/unloading port side. The front surface of the peripheral wall 22 is rotated toward the loading/unloading port when loading/unloading the substrate S, such that the peripheral wall 22 does not interfere with the loading/unloading path of the substrate S.

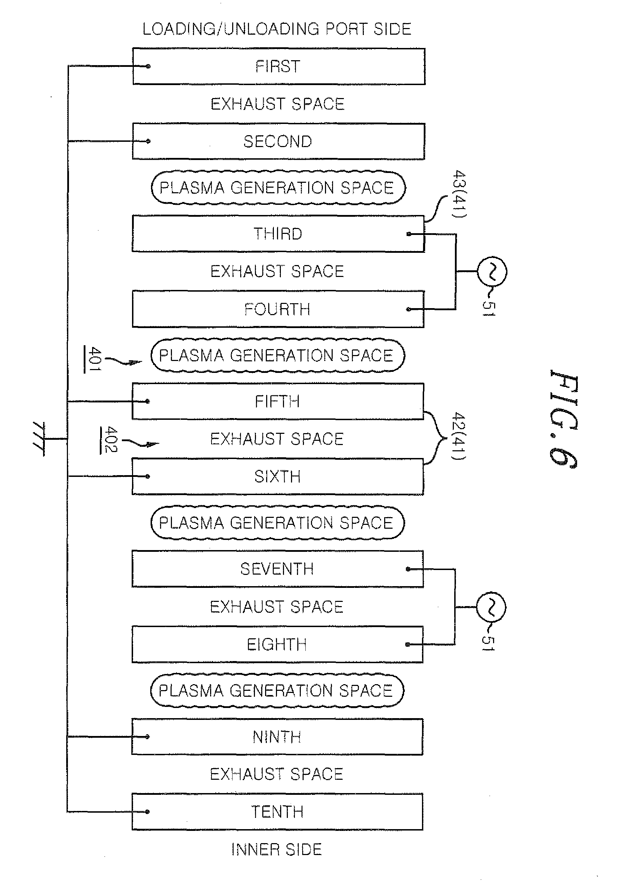

Further, as shown in FIG. 6, high frequency power supply units 51 are connected to four partitions 41 of the third, fourth, seventh and eighth partitions 41 when counted from the loading/unloading port side. For example, one high frequency power supply unit 51 is connected to a pair of the third and fourth partitions 41, and the other high frequency power supply unit 51 is connected to a pair of the seventh and eighth partitions 41. A high frequency power of, e.g., 100 MHz and 5000 W may be applied to these partitions 41. Meanwhile, six partitions 41 of the first, second, fifth, sixth, ninth and tenth partitions 41 when counted from the loading/unloading port side are grounded.

By the above configuration, the second and third partitions 41, the fourth and fifth partitions 41, the sixth and seventh partitions 41, and the eighth and ninth partitions 41 constitute parallel electrodes wherein the partitions 41 connected to the high frequency power supply units 51 are cathode electrodes 43 and the grounded partitions 41 are anode electrodes 42. Further, when a high frequency power is applied from the high frequency power supply units 51 while H₂ is supplied to the spaces 401 between these partitions 41 from the first gas flow paths 33, a capacitively coupled plasma is formed in the spaces 401 between these parallel electrodes and H₂ is converted into a plasma. In this respect, the spaces 401 formed between the second and third partitions 41, between the fourth and fifth partitions 41, between the sixth and seventh partitions 41, and between the eighth and ninth partitions 41 correspond to plasma generation spaces of this embodiment. Further, the parallel electrodes (cathode electrodes 43 and anode electrodes 42) and the high frequency power supply units 51 connected thereto constitute an activating mechanism for activating H₂ to generate a plasma.

Meanwhile, a common high frequency power supply unit 51 is connected to each of a pair of the third and fourth partitions 41 and a pair of the seventh and eighth partitions 41, so that the partitions in each pair are equipotential. Accordingly, although a gas is supplied to the spaces 402 between these partitions 41, a plasma is not formed. Further, since the first and second partitions 41, the fifth and sixth partitions 41, and the ninth and tenth partitions 41 are grounded and equipotential, in the same way, a plasma is not formed in the spaces 402 between these partitions 41. Further, since the evacuation openings 23 are provided on both surfaces of the peripheral wall 22 on the left and right sides of these spaces 402, a gas introduced into the spaces 402 is exhausted to the outside of the peripheral wall 22 through the evacuation openings 23. In this respect, the spaces 402 formed between the first and second partitions 41, between the third and fourth partitions 41, between the fifth and sixth partitions 41, between the seventh and eighth partitions 41, and between the ninth and tenth partitions 41 correspond to exhaust spaces of this embodiment. In this case, since the partitions 41 forming the anode electrodes 42 and the cathode electrodes 43 are fixed to the ceiling of the processing container 10 through the insulating member 31, the anode electrodes 42 and the cathode electrodes 43 are electrically insulated except for regions where capacitive coupling is formed.

To summarize the above configuration, in the film formation apparatus 1a of this embodiment, the partitions 41 are provided in parallel to each other as shown in FIG. 6, so that the plasma generation spaces 401 and the exhaust spaces 402 are alternately arranged. Further, as described above, the plasma generation spaces 401 and the exhaust spaces 402 communicate with each other through the opening formed between the bottom end of the partitions 41 and the substrate S mounted on the mounting table 2, so that a gas can flow from the plasma generation spaces 401 to the exhaust spaces 402 through the opening.

The film formation apparatus 1a includes a control unit 5, as shown in FIG. 1, such that each constituent parts of the film formation apparatus 1a is connected to and controlled by the control unit 5. The control unit 5 consists of, e.g., a computer (not shown) having a CPU and a storage part. The storage part stores a program for performing the actions of the film formation apparatus 1a, i.e., steps (commands) associated with the control and the like of the operations from loading the substrate S into the processing container 10 to unloading the substrate S after forming a µc-Si film having a predetermined thickness on the substrate S mounted on the mounting table 2. The program is stored in a storage medium such as hard disk, compact disk, magnetic optical disk and memory card, and installed on the computer therefrom.

Next, the actions of the film formation apparatus 1a having the above configuration will be described. First, when the substrate S is transferred while being held on the external transfer arm 100, the film formation apparatus 1a opens the gate valve 12 of the loading/unloading port 11 and rotates the peripheral wall 22 of the front surface side to ensure a loading path of the substrate S. Further, the transfer arm 100 is moved to the opening between the bottom end of the partitions 41 and the top surface of the mounting table 2. Then, when reaching a mounting position of the substrate S, the transfer arm 100 is moved down into the cutout portion 20 of the mounting table 2 such that the substrate S is delivered onto the mounting table 2.

When the delivery of the substrate S is completed, the transfer arm 100 is retracted from the processing container 10. The gate valve 12 is closed and, also, the peripheral wall 22 is rotated such that the peripheral wall 22 surrounds the substrate S. Along with this operation, the processing container 10 is vacuum evacuated such that an inner pressure of the processing container 10 is adjusted to, e.g., 670 Pa (5 Torr). At the same time, the temperature of the substrate S is controlled by the temperature control part 21 such that the temperature of the substrate S becomes, e.g. , 250°C.

When the pressure control in the processing container 10 and the temperature control of the substrate S are completed, H₂ is supplied, e.g., in a total amount of 100000 cc/min (in the standard conditions) from the first gas flow paths 33 into each of the plasma generation spaces 401. At the same time, a high frequency power is supplied from the high frequency power supply units 51 to each of the cathode electrodes 43 to convert H₂ into a plasma. Meanwhile, SiH₄ is supplied, e.g., in a total amount of 500 cc/min (in the standard conditions) from the second gas flow paths 411 into the lower portions of the plasma generation spaces 401.

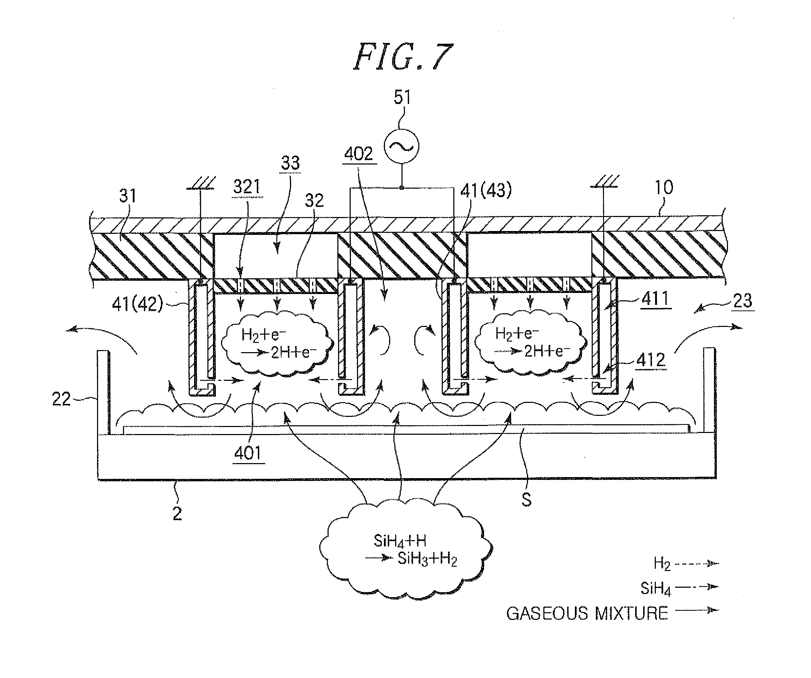

As shown schematically in FIG. 7, H₂ supplied from the first gas flow paths 33 forms a downward flow in the plasma generation spaces 401, and H₂ collides with electrons supplied from the parallel electrodes to be converted into a plasma, thereby forming active species. Since H₂ is a molecule consisting of only two hydrogen atoms, only hydrogen radicals are generated as active species from a hydrogen plasma as represented in the following Eq. (1):

H₂ + e- → 2H + e- (1)

Meanwhile, SiH₄ discharged from the discharge holes 412 of the second gas flow paths 411 is supplied to the lower portions of the plasma generation spaces 401 (lower end portions of the plasma generation spaces 401 in this embodiment). SiH₄ is mixed with the active species of H₂ that has flowed from the upstream side and flows downward. Accordingly, SiH₄ is hardly converted into a plasma, and does not contain unnecessary active species such as Si, SiH, and SiH₂ (even if it contains, the amount is small). In this state, SiH₄ is mixed with the active species of H₂ and then flows toward the substrate S located below the plasma generation spaces 401.

As a result, a gaseous mixture of SiH₄ and H radicals serving as the active species of H₂ is supplied to the surface of the substrate S. The reaction represented by the following Eq. (2) is carried out in the gaseous mixture.

SiH₄ + H → SiH₃ + H₂ (2)

Accordingly, SiH₃ is supplied in high concentration to the surface of the substrate S, and a µc-Si film with good quality is formed on the surface of the substrate S from SiH₃.

on the other hand, in the gaseous mixture, if SiH₃ generated by the above Eq. (2) also reacts with H radicals over time, SiH₂, SiH and si are sequentially generated. If the active species thereof, or polymer thereof, i.e., high-order silane or fine particles are incorporated in the µc-Si film, it may cause degradation of film quality.

However, in the film formation apparatus 1a of this embodiment, the plasma generation spaces 401 communicate with the exhaust spaces 402 through the opening between the bottom end of the partitions 41 and the substrate S. The evacuation openings 23 are provided on both left and right surfaces of the peripheral wall 22 at positions higher than the lower end of the plasma generation spaces 401, i.e., at positions higher than the opening. Further, the processing container 10 is always evacuated. Accordingly, after the gaseous mixture having flowed downward from the plasma generation spaces 401 reaches the surface of the substrate S, the gaseous mixture flows along the surface of the substrate S and flows into the exhaust spaces 402 through the opening between the partitions 41 and the substrate S. Then, the gaseous mixture changes its direction to flow upward and is immediately exhausted to the outside of the peripheral wall 22 through the evacuation openings 23.

In this embodiment, since the exhaust spaces 402 extend in the direction parallel to the short sides of the substrate S, it is possible to shorten the average residence time on the substrate S compared to, e.g., a case where the gaseous mixture flows in the direction parallel to the long sides of the substrate S. Further, even if the exhaust spaces 402 are formed along the long sides of the substrate S, it is possible to shorten the residence time compared to, e.g., a case where the gaseous mixture supplied to the central region of the substrate S flows diagonally on the substrate S. Thus, the exhaust spaces 402 serve to reduce the residence time of the gaseous mixture on the substrate S.

Further, since the gaseous mixture flowing on the surface of the substrate S changes its direction to flow upward by the action of the evacuation openings 23 provided in the peripheral wall 22, it is possible to further shorten the residence time of the gaseous mixture on the surface of the substrate S. Further, by the action of the exhaust spaces 402 or the evacuation openings 23, it possible to supply SiH₃ in high concentration to the surface of the substrate S, suppress generation of unnecessary active species, and obtain a µc-Si film with good quality.

By the mechanism described above, it is possible to obtain the above-described two actions: (1) SiH₃ can be supplied in high concentration to the surface of the substrate S while suppressing generation of unnecessary active species by suppressing SiH₄ from being converted into a plasma and reacting SiH₄ with H radicals, and (2) it is possible to suppress generation of unnecessary active species by suppressing the excessive reaction between SiH₄ and H radicals by rapidly discharging a gaseous mixture of SiH₄ and H radicals from the surface of the substrate S.

In this way, film formation on the surface of the substrate S is performed only for a preset period of time. If the µc-Si film having a desired thickness is obtained, the supply of SiH₄ and H₂, the application of high frequency power and vacuum evacuation are stopped. The substrate S is unloaded from the processing container 10 by the transfer arm 100 in an opposite operation to that when loading the substrate S, thereby completing a series of operations.

In accordance with the film formation apparatus 1a of this embodiment, the following effects can be obtained. That is, the space above the substrate S mounted on the mounting table 2 is divided in a transverse direction into the plasma generation spaces 401 and the exhaust spaces 402 by the partitions 41, and H₂ is activated in the plasma generation spaces 401 to generate a plasma. Further, SiH₄ is supplied to the lower portions of the plasma generation spaces 401, and the gaseous mixture supplied to the substrate S is exhausted from the exhaust spaces 402. Accordingly, SiH₄ is reacted with active species (H radicals) generated from the H₂ gas while suppressing the promotion of decomposition due to contact with the plasma, so that desired SiH₃ can be present in high concentration in the vicinity of the substrate S, and the µc-Si film with good quality can be formed.

In this case, if the lower portions of the plasma generation spaces 401 are located at positions corresponding to the lower half of the plasma generation spaces 401, more preferably, at positions corresponding to about one quarter of the partitions 41 from the bottom end of the partitions 41, it is possible to obtain the effect of the present invention of suppressing generation of unnecessary active species due to conversion of SiH₄ into a plasma.

Further, SiH₄ may be supplied to the side lower than the plasma generation spaces 401 without being limited to a case where SiH₄ is supplied to the lower portions of the plasma generation spaces 401. In this case, the discharge holes 412 may be provided on, e.g., the lower end surfaces of the partitions 41 to discharge SiH₄ toward the substrate S. Alternatively, a pipe dedicated to supply SiH₄ may be arranged at a position lower than the plasma generation spaces 401 such that SiH₄ is supplied from the discharge holes 412 provided in the pipe.

### <Second Embodiment>

Next, a second embodiment will be described.

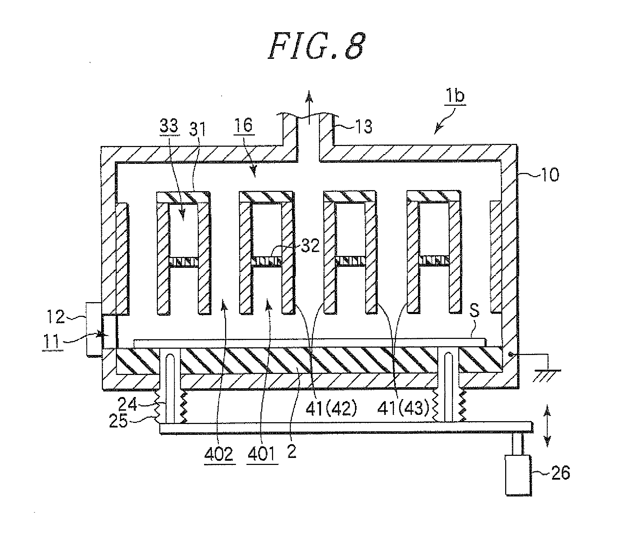

In the above first embodiment, the gaseous mixture supplied to the substrate S is exhausted laterally through the peripheral wall 22 disposed around the periphery of the substrate S. However, without being limited thereto, in this embodiment, an exhaust passage is provided in, e.g. , the ceiling of the processing container such that the gaseous mixture is exhausted from the upper side. FIGS. 8 to 10 illustrate a configuration of a film formation apparatus 1b in accordance with the second embodiment, in which the gaseous mixture supplied to the surface of the substrate S is exhausted toward the ceiling of the processing container 10. Further, in this embodiment and the following third and later embodiments, the same reference numerals as those of the first embodiment are assigned to components with functions similar to those of the film formation apparatus 1a.

The film formation apparatus 1b of this embodiment is different from the film formation apparatus 1a of the first embodiment in that the film formation apparatus 1b does not include the peripheral wall 22 surrounding the substrate S mounted on the mounting table 2, the exhaust passage 13 is provided in the ceiling of the processing container 10, and a gathering exhaust section 16 which communicates with each of the exhaust spaces 402 and in which gaseous mixtures are merged before being exhausted toward the exhaust passage 13 is provided above the first gas flow paths 33.

In this embodiment, the insulating member 31 is provided to cover the upper surface of two partitions 41 with the shower plate 32 provided therebetween, and the first gas flow path 33 is formed in the space surrounded by the two partitions 41, the shower plate 32 and the insulating member 31. Further, the delivery of the substrate S is performed by using lifting pins 24. In FIG. 8, reference numeral 25 denotes bellows surrounding the lifting pins 24 to maintain the vacuum atmosphere in the processing container 10, and reference numeral 26 denotes a lifting mechanism for lifting up and down the lifting pins 24.

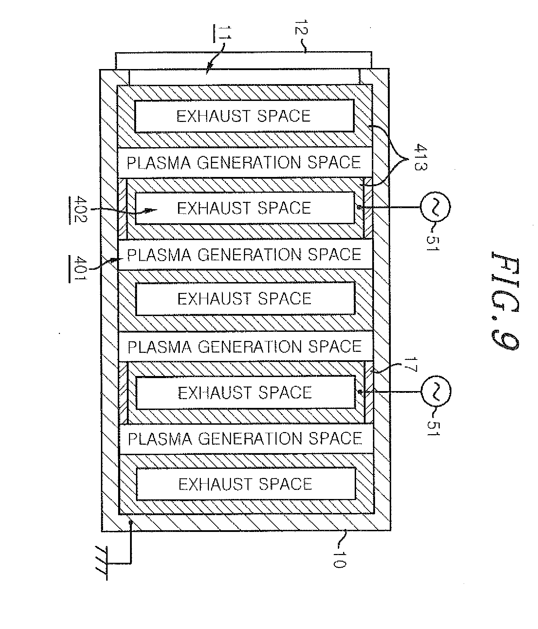

In the film formation apparatus 1b of this embodiment, for example, the partitions 41 are formed of square tubular members 413 having a rectangular cross-section as seen from the top. The square tubular members 413 are disposed in the processing container 10 in a state fixed to the sidewall of the processing container 10. Further, while the first, third and fifth square tubular members 413 when viewed from the loading/unloading port side are fixed to be electrically connected to the grounded processing container 10, the second and fourth square tubular members 413 are fixed to the processing container 10 through insulating members 17, and are connected to the high frequency power supply units 51. Accordingly, in the same way as the film formation apparatus 1a of the first embodiment shown in FIG. 6, the plasma generation spaces 401 and the exhaust spaces 402 may be alternately arranged (see FIG. 9).

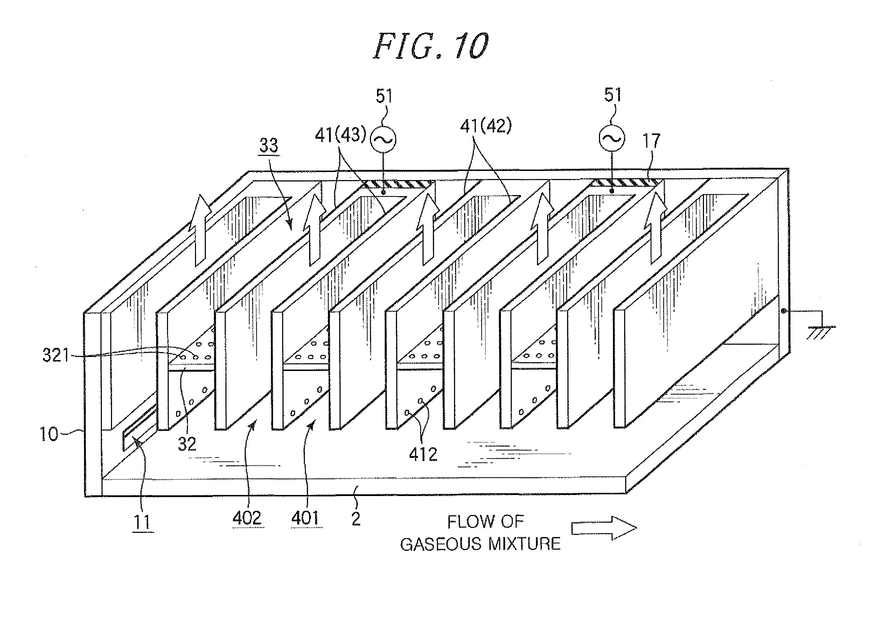

Also in the film formation apparatus 1b, in the same way as the film formation apparatus 1a of the first embodiment, H₂ is supplied to the plasma generation spaces 401 to generate a plasma, and H radicals obtained from the plasma are mixed with SiH₄ supplied to the lower portions of the plasma generation spaces 401, so that SiH₃ can be supplied in high concentration to the substrate S. In the film formation apparatus 1b of this embodiment, the gaseous mixture having flowed into the exhaust spaces 402 while flowing on the surface of the substrate S flows upward in the exhaust spaces 402 toward the gathering exhaust section 16 as shown in FIG. 10. Accordingly, the residence time of the gaseous mixture on the substrate S becomes shorter. Consequently, it is possible to suppress generation of unnecessary active species and the like depending on the progress of radical reaction, and form a µc-Si film with good quality.

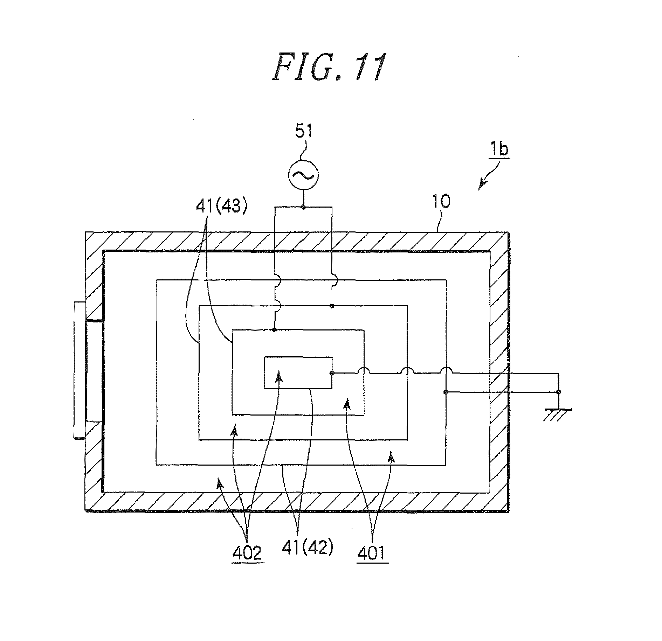

In this case, in evacuation of the gaseous mixture toward the ceiling of the processing container 10, preferably, the exhaust spaces 402 communicate with the ceiling portion through which the gaseous mixture is exhausted. For example, as shown in FIG. 11, it may be configured such that the partitions 41 are provided in a concentric shape and a plasma is formed between parallel electrodes (anode electrodes 42 and cathode electrodes 43) formed by the partitions 41.

### <Third Embodiment>

Next, a third embodiment will be described.

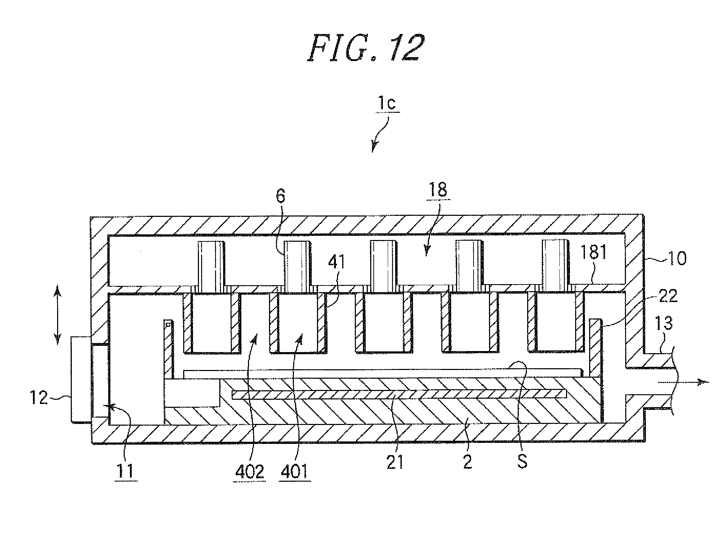

This embodiment illustrates an example in which microwave antenna units are provided as an activating mechanism at positions higher than the plasma generation spaces. FIGS. 12 to 16 illustrate a configuration of a film formation apparatus 1c of the third embodiment in which microwave antenna units 6 serving as an activating mechanism are provided at positions higher than the plasma generation spaces 401.

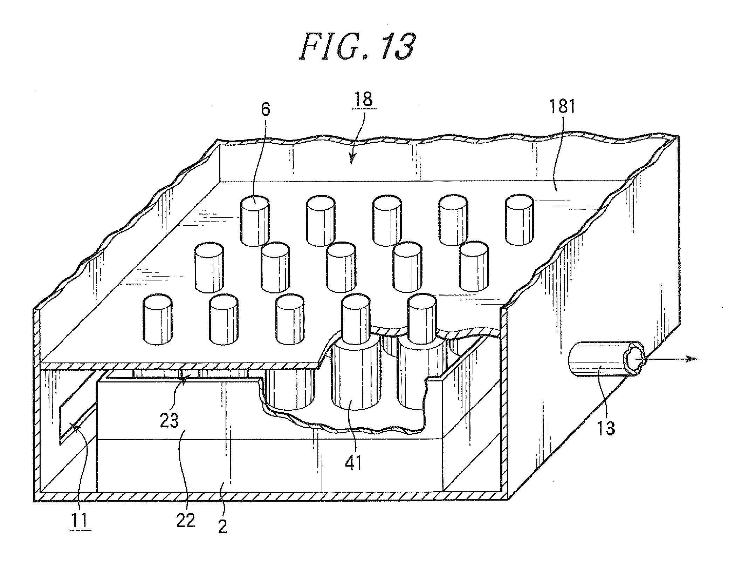

In the film formation apparatus 1c of this embodiment, as shown in FIGS. 12 and 13, the processing container 10 is divided into upper and lower spaces by a top plate 181. The mounting table 2 of the substrate S is placed in the lower space in the same way as the film formation apparatus 1a, while an accommodating section 18 which accommodates the microwave antenna units 6 is formed in the upper space.

As shown in FIG. 13, the microwave antenna units 6 are arranged at respective intersections of a matrix having, e.g., three columns in a lateral direction and, e.g., five rows in a longitudinal direction in the accommodating section 18. A total of fifteen microwave antenna units 6 are distributed and arranged in an insular shape on the top plate 181. Further, the partitions 41 for forming the plasma generation spaces 401 are arranged in the lower space while the top plate 181 on which the microwave antenna units 6 are arranged is interposed between the upper and lower spaces.

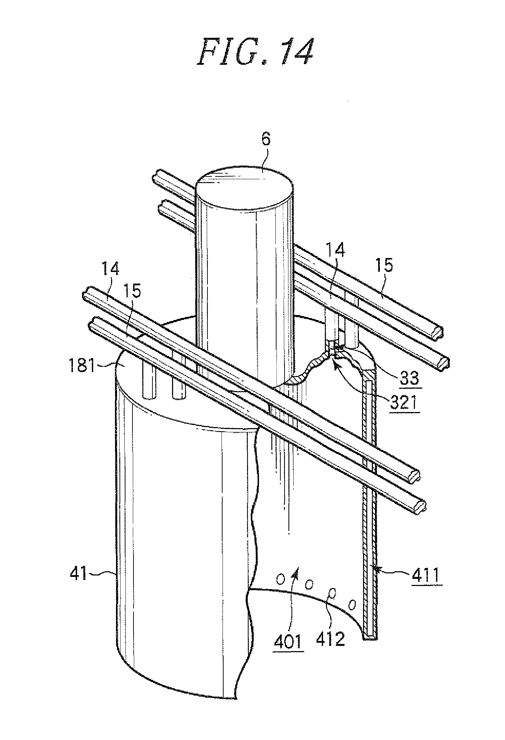

The partitions 41 of this embodiment are formed, e.g., in a cylindrical shape, as shown in FIGS. 13 and 14, to surround the spaces below the microwave antenna units 6. Consequently, a total of fifteen cylindrical partitions 41 are arranged in an insular shape in the space in which the substrate S is mounted. The spaces inside the partitions 41 correspond to the plasma generation spaces 401, and the spaces outside the partitions 41 correspond to the exhaust spaces 402.

The top plate 181 forming the ceiling portions of the plasma generation spaces 401 is communicated with the first gas supply pipe 14 through the first gas flow paths 33. H₂ that has been supplied from the first gas supply pipe 14 is supplied to the upper portions of the plasma generation spaces 401 through the first gas flow paths 33 and the discharge holes 321. Further, for example, the partitions 41 have cavities therein, and the cavities constitute the second gas flow paths 411 for supplying SiH₄ to the lower portions of the plasma generation spaces 401. Further, the second gas flow path 411 is communicated with the second gas supply pipe 15, while the discharge holes 412 are provided along the inner peripheral surface of the partition 41 in the vicinity of the lower end portion of the plasma generation spaces 401, so that SiH₄ can be supplied to the lower portions of the plasma generation spaces 401 through the discharge holes 412.

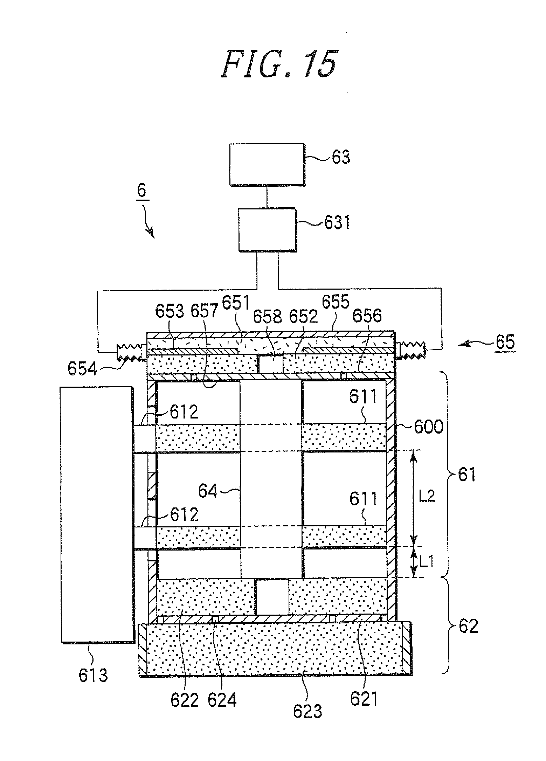

Next, the configuration of the microwave antenna units 6 will be described with reference to FIG. 15. Each of the microwave antenna units 6 includes a tuner 61 and an antenna section 62. The tuner 61 and the antenna section 62 are received sequentially from top to bottom in a housing 600 which forms an outer conductor of a coaxial cylindrical tube and is made of, e.g., metal. The antenna section 62 of the lower side includes a planar slot antenna plate 621 having a disk shape, a ring-shaped slow-wave member 622 which is provided on the planar slot antenna plate 621 and shortens the wavelength of the microwave in the vacuum atmosphere to adjust the density of the plasma, and a top plate 623 which is provided below the planar slot antenna plate 621 and is formed of a dielectric material.

Two slots having an arcuate shape in the plan view are formed on the planar slot antenna plate 621 to face each other. Further, a metal rod 64 forming an inner conductor of the coaxial tube is connected to a central portion of the upper surface of the planar slot antenna plate 621 to extend upward from a central portion of the slow-wave member 622. As shown in FIG. 15, the microwave antenna units 6 are connected in parallel to each other through a common microwave output unit 63 and a common amplifier 631. The top plate 623 serves to introduce the microwave outputted from the microwave output unit into the plasma generation spaces 401.

In the tuner 61, e.g. , two ring-shaped slags 611 made of a dielectric material are separated from each other vertically, and the metal rod 64 passes through the cores of the slags 611 in a vertical direction. Each of the slags 611 is connected to a drive unit 613 through an arm 612 extending outward in a radial direction of the housing 600 such that the slags 611 are vertically movable. Height positions L1 and L2 of the slags 611 are adjusted such that the impedance becomes, e.g., 50 Ω when viewing the microwave antenna units 6 on the downstream side from the microwave output unit 63. Further, the tuner 61 and the planar slot antenna plate 621 are arranged to be adjacent to each other to form a lumped constant circuit present in one wavelength of the microwave, and function as a resonator.

A power feeding excitation plate 65 for performing a contactless power feeding operation is provided on the top of the metal rod 64 passing through the tuner 61. The power feeding excitation plate 65 includes a dielectric board 651 consisting of a printed wiring board, and a ring-shaped dielectric member 652 disposed below the dielectric board 651. On the backside of the dielectric board 651 are formed microstrip lines 653 consisting of two conductors which are separated from each other and extend in a diametrical direction to face each other while a core portion of the dielectric board 651 is interposed therebetween.

Connectors 654 are respectively attached to the ends of the microstrip lines 653 located on a side peripheral surface of the dielectric board 651. The amplifier 631 is connected to each of the connectors 654. Accordingly, the power synthesized (spatially synthesized) microwave is fed to the tuner 61 through two connectors 654. In FIG. 15, reference numeral 655 denotes a reflective plate for reflecting the microwave.

On the lower surface of the dielectric member 652 is provided a disk-shaped slot antenna 656 which is plated with, e.g., copper and has two slots 657 formed in an arcuate shape in the plan view to face each other. The microwave antenna units 6 are formed such that the length dimension of the slots 657 is, e.g., 1/2 X λg (λg: wavelength of the microwave in the tube). The dielectric member 652 functions as a resonator with the slot antenna 656. A central conductor 658 is provided at the center of the dielectric member 652 to pass through the dielectric member 652 in a vertical direction such that the central conductor 658 is connected to the lower surface side of the dielectric board 651 and the slot antenna 656.

When a microwave of a predetermined power, e.g., a microwave having a frequency of 2.45 GHz and power of 2000 W to 10000 W, is supplied from the microwave output unit 63 of the microwave antenna units 6 having the above configuration, the microwave is amplified by the amplifier 631 and is distributed to each of the microwave antenna units 6 by a distributor (not shown). Further, the amplified microwave is inputted through two microstrip lines 653 in each of the microwave antenna units 6. After synthesis, the microwave is supplied to the plasma generation spaces 401 through the planar slot antenna plate 621.

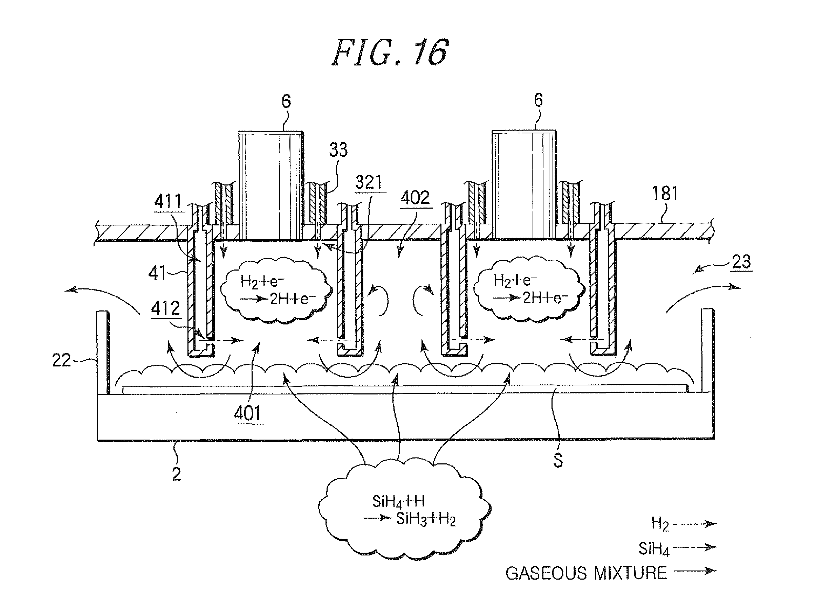

As a result, as shown in FIG. 16, H₂ supplied to the plasma generation spaces 401 is converted into a plasma by the microwave fed from the microwave antenna units 6 to generate H radicals serving as active species. The H radials react with SiH₄ supplied to the lower portions of the plasma generation spaces 401, thereby supplying SiH₃ in high concentration to the surface of the substrate S. Further, a gaseous mixture of H radicals and SiH₄ flows into the space (exhaust space 402) in the outer periphery of the cylindrical partitions 41. The gaseous mixture flows laterally in the exhaust spaces 402, and is discharged to the outside of the peripheral wall 22 through the openings between the top plate 181 and the peripheral wall 22. In this respect, the openings between the top plate 181 and the peripheral wall 22 correspond to vacuum evacuation openings of this embodiment. In this case, the microwave antenna units 6 installed in the film formation apparatus 1c of this embodiment are not limited to those shown in FIG. 15, and regular waveguides connected to the microwave output unit 63 may be used.

### <Fourth Embodiment>

Next, a fourth embodiment will be described.

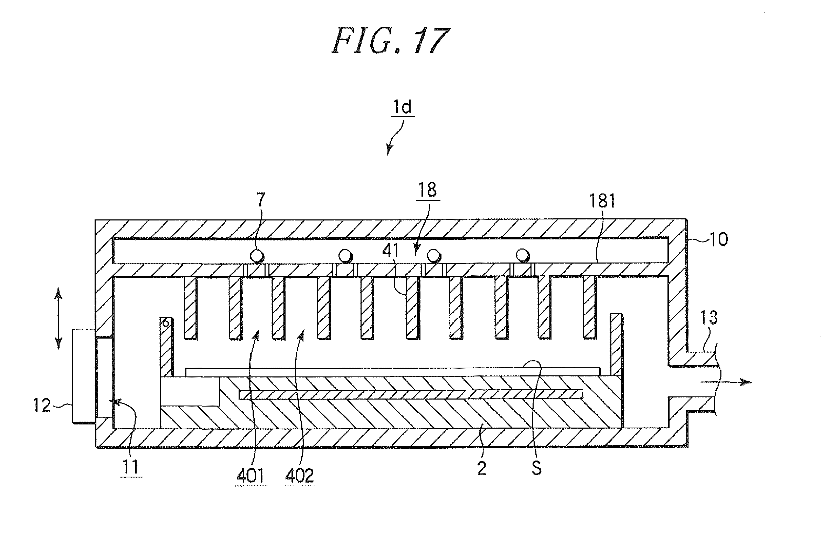

In the above third embodiment, the example in which the microwave antenna units 6 are provided as an activating mechanism above the plasma generation spaces has been illustrated. However, without being limited thereto, in this embodiment, inductively coupled plasma (ICP) antennas are provided as an activating mechanism above the plasma generation spaces. FIGS. 17 to 20 illustrate a configuration of a film formation apparatus 1d in accordance with the fourth embodiment in which ICP antennas 7 are provided as an activating mechanism above the plasma generation spaces 401.

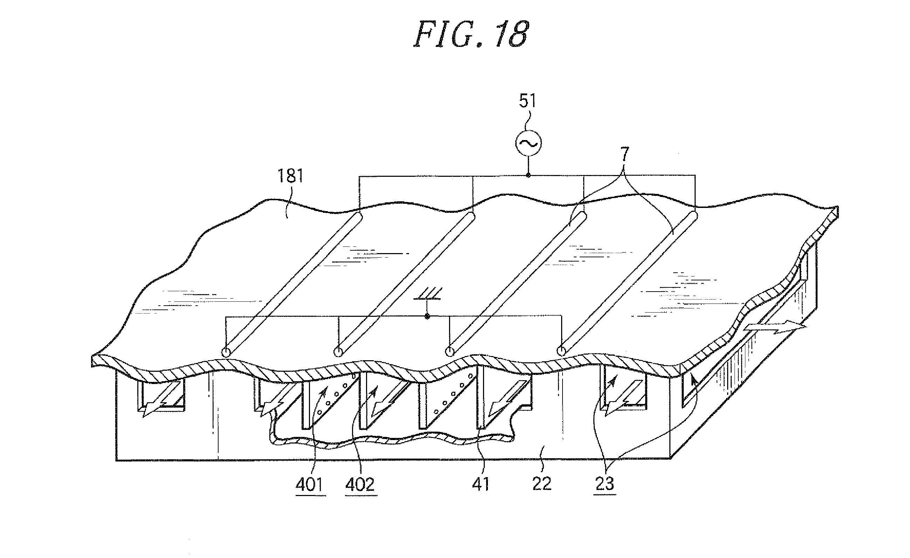

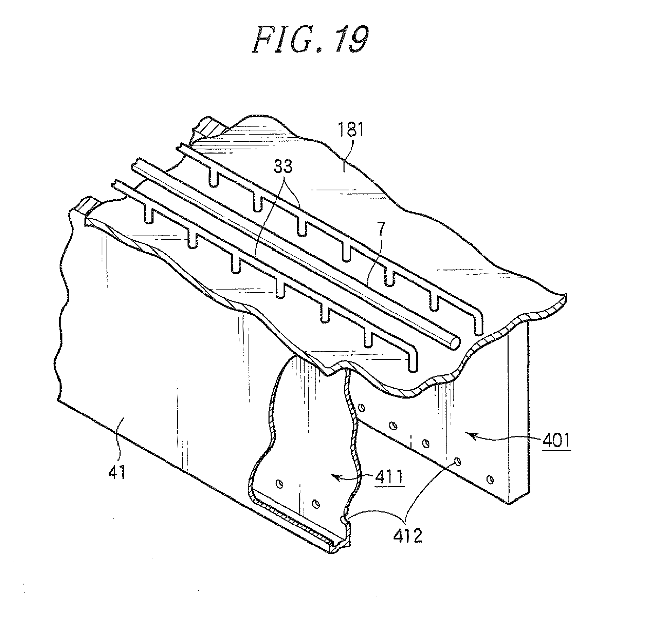

In the film formation apparatus 1d of this embodiment, for example, as shown in FIGS. 17 and 18, the ICP antennas 7 having, e.g., a straight bar shape and extending in the extending direction of the plasma generation spaces 401 are provided in the accommodating section 18 defined by the top plate 181 above the plasma generation spaces 401. Such configuration makes the film formation apparatus 1d different from the film formation apparatus 1a of the first embodiment in which the parallel electrodes are formed by connecting each of the partitions 41 to the high frequency power supply units 51 or the ground. Further, as shown in FIG. 19, in the film formation apparatus 1d, the first gas flow paths 33 are arranged in the extending direction of the plasma generation spaces 401 on the upper surface of the top plate 181 and H₂ is supplied through the first gas flow paths 33, unlike the film formation apparatus 1a in which H₂ is supplied through the first gas flow paths 33 that are the spaces disposed above the plasma generation spaces 401.

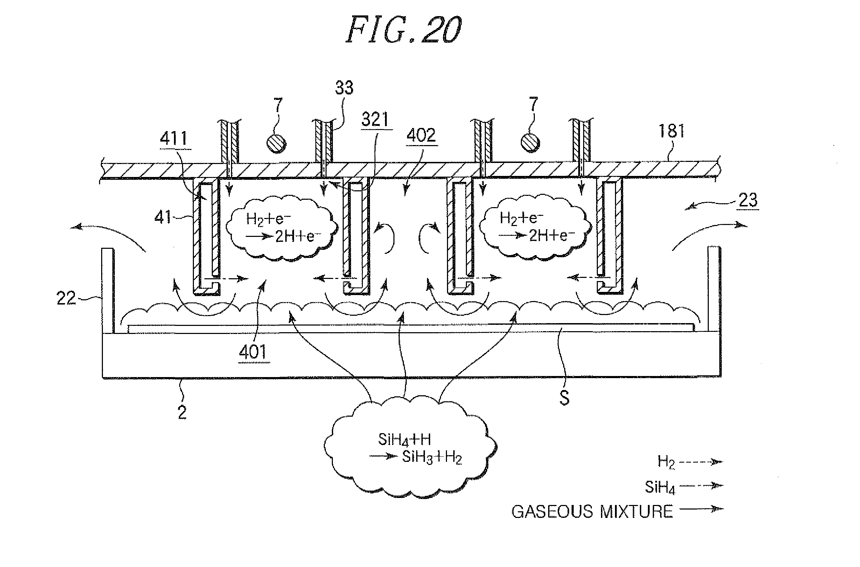

In accordance with the film formation apparatus 1d of this embodiment, four ICP antennas 7 are arranged in the accommodating section 18 along the plasma generation spaces 401. One-side ends of the ICP antennas 7 are connected in parallel to the common high frequency power supply unit 51 for supplying a power of, e.g., 13.56 MHz and 5000 W, while the other-side ends of the ICP antennas 7 are grounded. Further, an induction field is formed in the plasma generation spaces 401 by applying a high frequency power to the ICP antennas 7 from the high frequency power supply unit 51. As shown in FIG. 20, H₂ supplied from the first gas flow paths 33 is converted into an inductively coupled plasma, and SiH₄ is supplied to the lower portions of the partitions 41, thereby supplying SiH₃ in high concentration to the surface of the substrate S.

Further, the gaseous mixture having flowed into the exhaust spaces 402 is guided laterally in the processing container 10 along the exhaust spaces 402. The gaseous mixture is exhausted through the evacuation openings 23 provided at positions higher than the bottom end of the partitions 41. Accordingly, the gas flow direction is changed to an upward direction of the substrate S, and it is possible to shorten the residence time of the gaseous mixture on the surface of the substrate S, thereby forming a µc-Si film with good quality.

The ICP antennas 7 of the film formation apparatus 1d are not limited to the straight bar-shaped antennas. For example, the ICP antennas 7 may be formed in an annular shape having a cutout portion, and may be distributed and arranged in an insular shape on the top plate 181 as in the film formation apparatus 1c of the third embodiment. In this case, by connecting one-side ends of the ICP antennas 7 formed in an annular shape having a cutout portion to the high frequency power supply unit 51 and grounding the other-side ends of the ICP antennas 7, an inductively coupled plasma may be formed on the bottom side of the annular ICP antennas 7. Accordingly, also in this case, preferably, the cylindrical partitions 41 may be provided to surround the plasma generation spaces below the ICP antennas 7.

Further, although the microwave antenna units 6 are distributed and arranged in an insular shape on the top plate 181 in the film formation apparatus 1c of the third embodiment, it is not limited thereto. In the same way as the film formation apparatus 1d of this embodiment, in the film formation apparatus 1c, flat plate-shaped partitions 41 may be arranged at equal intervals in a longitudinal direction, and the microwave antenna units 6 may be arranged along the plasma generation spaces 401 extending in a direction perpendicular to the long sides of the substrate S.

In the film formation apparatuses 1a, 1c and 1d of the first, third and fourth embodiments, the peripheral wall 22 is provided around the substrate S, and the evacuation openings 23 formed in the peripheral wall 22 or the opening between the peripheral wall 22 and the top plate 181 serves as a vacuum evacuation opening of the gas on the substrate S. However, the peripheral wall 22 may not be provided on the mounting table 2. In this case, a portion connected to the exhaust passage 13 provided on the sidewall of the processing container 10 serves as a vacuum evacuation opening.

### <Fifth Embodiment>

Next, a fifth embodiment will be described.

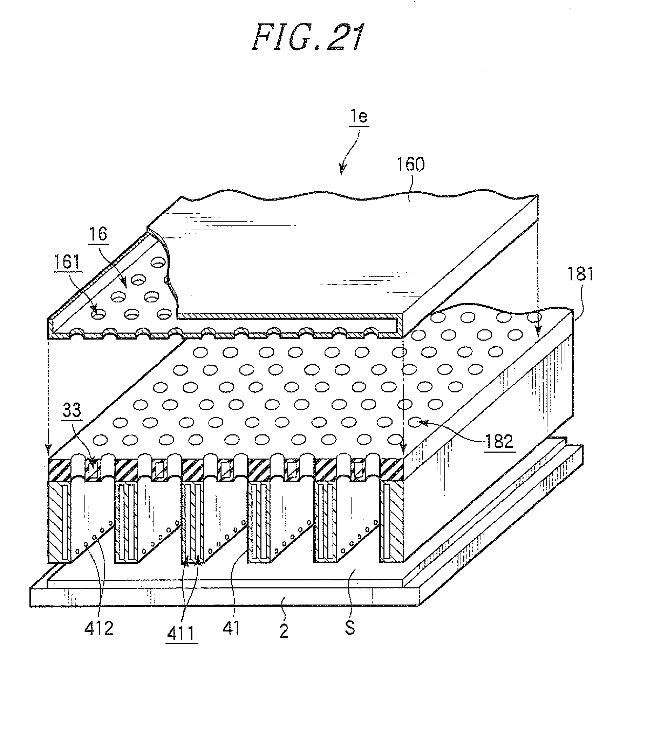

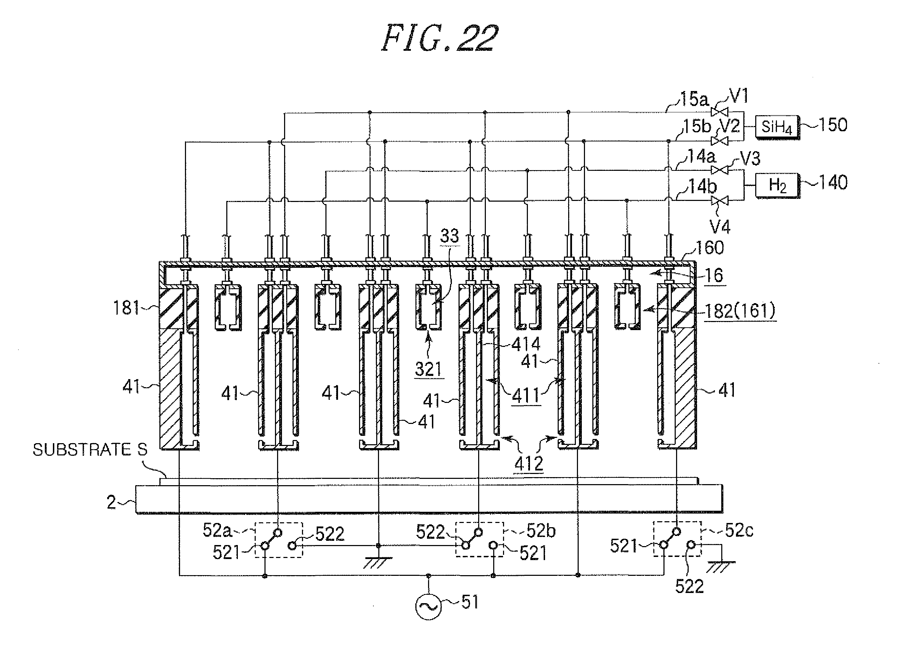

FIGS. 21 and 22 illustrate a configuration of a film formation apparatus 1e in accordance with a fifth embodiment. The film formation apparatus 1e of this embodiment has the same feature as the film formation apparatus 1b of the second embodiment that has been described with reference to FIGS. 8 to 10 in that the plasma generation spaces 401 and the exhaust spaces 402 are alternately arranged. Meanwhile, the film formation apparatus 1e of this embodiment is different from the film formation apparatus 1b of the second embodiment in that the space formed between two partitions 41 facing each other can be changed over time in the order of plasma generation space 401 → exhaust space 402 → plasma generation space 401 → ···.

As shown in FIGS. 21 and 22, the film formation apparatus 1e includes the partitions 41 to divide the space above the substrate S mounted on the mounting table 2 in a transverse direction, e.g., from left to right in the figure. The partitions 41 are supported by the common top plate 181 formed of, e.g., an insulating material. Although an example of providing six partitions 41 is illustrated in FIGS. 21 and 22 for convenience of illustration, the number of the partitions 41 is not limited thereto.

Each of the partitions 41 includes two spaces which are separated into left and right spaces by an inner wall plate 414 extending in a vertical direction. The respective spaces form the second gas flow paths 411 for supplying SiH₄ to, e.g., the lower end portions of the partitions 41 through the discharge holes 412. Further, in the example of FIGS. 21 and 22, only one second gas flow path 411 is formed in each of the foremost and rearmost partitions 41. However, two second gas flow paths 411 may be provided in each of foremost and rearmost partitions 41 in the same way as the other partitions 41.

As shown in FIG. 22, the second gas flow paths 411 formed in the partitions 41 are connected to a SiH₄ supply source 150 through second gas supply pipes 15a and 15b. Further, two second gas flow paths 411 formed in each of the partitions 41 are respectively connected to the second gas supply pipes 15a and 15b of different lines. In this embodiment, the second gas supply pipe 15a of one side is connected to the right second gas flow path 411 of the second partition 41 from the left side, the left second gas flow path 411 of the third partition 41 from the left side, the right second gas flow path 411 of the fourth partition 41 from the left side, and the left second gas flow path 411 of the fifth partition 41 from the left side. Further, the second gas supply pipe 15b of the other side is connected to the second gas flow path 411 of the first partition 41 from the left side, the left second gas flow path 411 of the second partition 41 from the left side, the right second gas flow path 411 of the third partition 41 from the left side, the left second gas flow path 411 of the fourth partition 41 from the left side, the right second gas flow path 411 of the fifth partition 41 from the left side, and the second gas flow path 411 of the sixth partition 41 from the left side.

Further, the first gas flow path 33 is formed in the top plate 181 at an approximately central position between two partitions 41 facing each other to extend in parallel to these partitions 41. The first gas flow path 33 supplies H₂ into the space between two partitions 41 through the discharge holes 321. The first gas flow paths 33 are connected to a H₂ supply source 140 through first gas supply pipes 14a and 14b, and each of the first gas flow paths 33 is connected to either one of the first gas supply pipes 14a and 14b of different lines. In this embodiment, the first gas supply pipe 14a is connected to the first gas flow paths 33 provided between the second and third partitions 41 and between the fourth and fifth partitions 41 when counted from the left side in the figure. The first gas supply pipe 14b is connected to the first gas flow paths 33 provided between the first and second partitions 41, between the third and fourth partitions 41 and between the fifth and sixth partitions 41 when counted from the left side in the figure. Further, the discharge holes 321 provided in the first gas flow paths 33 are opened in a downward direction to supply H₂ into the space formed between the facing partitions 41 toward the substrate S mounted on the mounting table 2.

opening/closing valves V1 to V4 are provided at the second gas supply pipes 15a and 15b and the first gas supply pipes 14a and 14b, so that the supply and interruption of SiH₄ or H₂ can be performed for each line. The opening/closing valves V1 to V4 constitute a gas supply switching section of this embodiment. In the following description, the supply pipes 15a and 14a marked with a sign of "a" are referred to as a first line and the supply pipes 15b and 14b marked with a sign of "b" are referred to as a second line to distinguish the lines from each other.

Next, an exhaust system will be described.

The top plate 181 supporting the partitions 41 is provided with exhaust holes 182 passing through the top plate 181 in a vertical direction. Further, an exhaust member 160 formed in, e.g., a flat shape and having a cavity therein is disposed on an upper surface of the top plate 181. Further, gas inlet holes 161 are provided on a lower surface of the exhaust member 160 at positions corresponding to the exhaust holes 182. The exhaust holes 182 are connected to the gas inlet holes 161, so that a gas below the top plate 181 can be discharged toward the cavity of the exhaust member 160. The cavity is connected to, e.g., an exhaust passage (not shown), and serves as the gathering exhaust section 16 for exhausting H₂ and SiH₄ after being supplied to the substrate S.

Next, a power system will be described.

In the film formation apparatus 1e of this embodiment, when counted from the left side of the figure, the first and fifth partitions 41 is always connected to the high frequency power supply unit 51, while the third partition 41 is grounded. Further, a connection destination of each of the second, fourth and sixth partitions 41 may be switched between the ground and a power terminal of the high frequency power supply unit 51 by switches 52a to 52c serving as a connection switching unit. Each of the switches 52a to 52c shown in FIG. 22 may be connected, as a connection destination, to any of a contact point 521 on the side of the high frequency power supply unit 51 and a contact point 522 on the side of the ground.

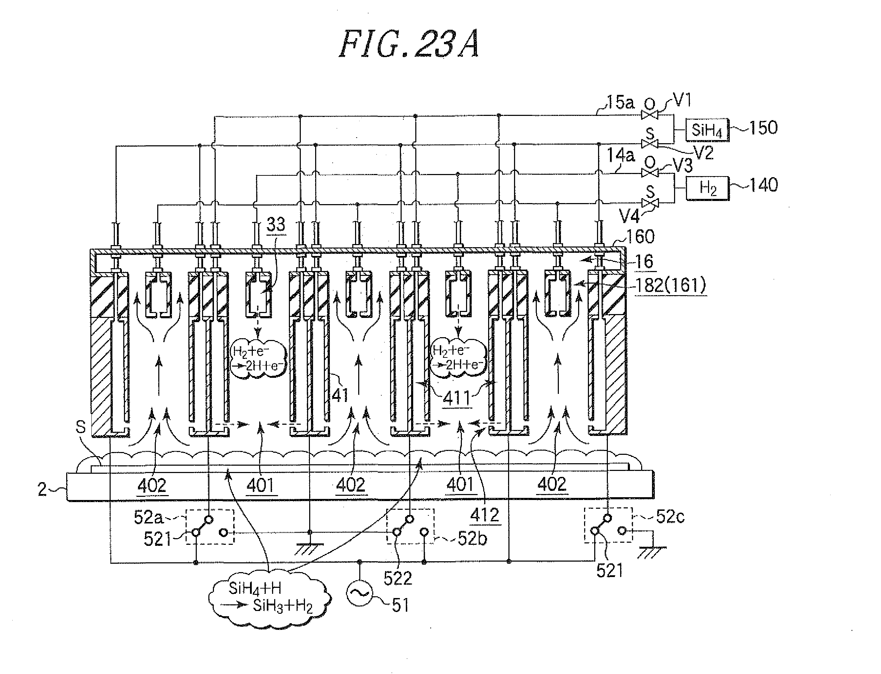

In the film formation apparatus 1e having the above configuration, as shown in FIG. 23A, the switches 52a and 52c are connected to the contact points 521 on the side of the high frequency power supply unit 51, while the switch 52b is connected to the contact point 522 on the side of the ground. Accordingly, a high frequency power is supplied to the first, second, fifth and sixth partitions 41, and the third and fourth partitions 41 are grounded.

Further, if one side of the partitions 41 facing each other is connected to the high frequency power supply unit 51, and the other side thereof is grounded, one side serves as the cathode electrode 43 and the other side serves as the anode electrode 42, thereby forming parallel electrodes. Accordingly, when H₂ is supplied from the first gas flow paths 33 to the spaces between the parallel electrodes, the spaces become the plasma generation spaces 401 in which H₂ is converted into a plasma. In an example of FIG. 23A, the plasma generation spaces 401 are formed between the second and third partitions 41 and between the fourth and fifth partitions 41.

In contrast, all of the first and second partitions 41 and the fifth and sixth partitions 41 are connected to the high frequency power supply unit 51, and the third and fourth partitions 41 are grounded. Accordingly, the spaces between the first and second partitions 41, between the third and fourth partitions 41 and between the fifth and sixth partitions 41 are equipotential, and a plasma is not formed therein although H₂ is supplied.

In this case, if the valve V3 of the first gas supply pipe 14a and the valve V1 of the second gas supply pipe 15a on the first line side are opened (represented by "O" in FIG. 23A) in synchronization with selection of the connection destination by the switches 52a to 52c, H₂ is supplied downward from the first gas flow paths 33 into the plasma generation spaces 401, so that H₂ is converted into a plasma to generate H radicals. Further, SiH₄ is supplied to the lower side of the plasma generation spaces 401, so that H radicals are mixed with SiH₄, thereby supplying SiH₃, required for growth of the µc-Si film, in high concentration to the surface of the substrate S.

Meanwhile, the valve V4 of the first gas supply pipe 14b and the valve V2 of the second gas supply pipe 15b on the second line side, which are connected to the spaces in which a plasma is not formed, are closed (represented by "S" in FIG. 23A). Further, by performing evacuation toward the exhaust passage through the gathering exhaust section 16, a gaseous mixture of H radicals and SiH₄ in contact with the substrate S below the plasma generation spaces 401 changes its direction to flow upward. Then, the gaseous mixture is introduced into the gathering exhaust section 16 through the exhaust holes 182 (and the gas inlet holes 161) and exhausted.

Accordingly, the spaces between the facing partitions 41 which are equipotential, H₂ or SiH₄ being not supplied to the spaces from the first and second gas flow paths 33 and 411, constitute the exhaust spaces 402 for exhausting the gaseous mixture supplied to the surface of the substrate S. In this embodiment, since the gaseous mixture supplied to the surface of the substrate S flows upward in the exhaust spaces 402 toward the gathering exhaust section 16, in the same way as in the previous embodiment, it is possible to shorten the residence time of the gaseous mixture on the substrate S and form a µc-Si film with good quality.

In this case, since the plasma generation spaces 401 are communicate with the gathering exhaust section 16 through the exhaust holes 182 in the same way as the exhaust spaces 402, there may be concern about whether H₂ supplied from the first gas flow paths 33 flows toward the gathering exhaust section 16 and is not able to reach the surface of substrate S mounted on the mounting table 2. However, as described above, the discharge holes 321 of the first gas flow paths 33 are opened downward such that H₂ is discharged toward the plasma generation spaces 401. By this configuration, most of H₂ supplied from the discharge holes 321 flows in a downward direction to reach the substrate S, which can be confirmed by simulation using a fluid simulator.

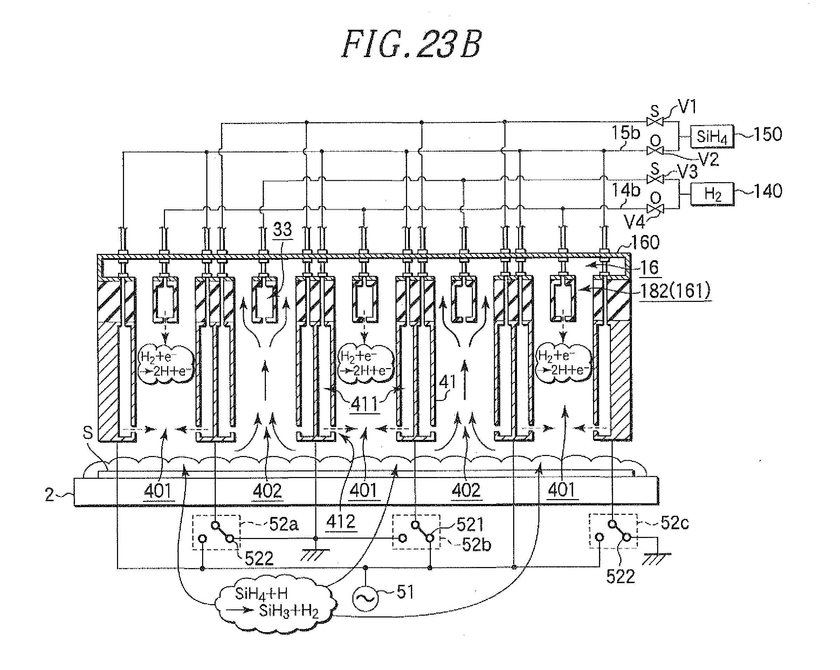

Once film formation is performed only for a predetermined period of time, e.g., few seconds to several minutes, in a state shown in FIGS. 23A, switching is carried out such that the switches 52a and 52c are connected to the contact points 522 on the side of the ground and the switch 52b is connected to the contact point 521 on the side of the high frequency power supply unit 51 as shown in FIG. 23B. Consequently, parallel electrodes are formed by the first and second partitions 41, the third and fourth partitions 41, and the fifth and sixth partitions 41, while the spaces between the second and third partitions 41 and between the fourth and fifth partitions 41 become equipotential.

In synchronization with switching operations of the switches 52a to 52c, the valve V4 of the first gas supply pipe 14b and the valve V2 of the second gas supply pipe 15b on the second line side, which are connected to the spaces in which the parallel electrodes are formed, are opened. Further, the valve V3 of the first gas supply pipe 14a and the valve V1 of the second gas supply pipe 15a on the first line side are closed. Accordingly, the spaces in which the parallel electrodes are formed may be switched to the plasma generation spaces 401 and the equipotential spaces may be switched to the exhaust spaces 402. Further, also in FIG. 23B, the open valves are represented by "O" and the closed valves are represented by "S."

Consequently, regions corresponding to the plasma generation spaces 401 in the state of FIG. 23A are switched to the exhaust spaces 402 in the state of FIG. 23B. On the other hand, regions corresponding to the exhaust spaces 402 in the state of FIG. 23A are switched to the plasma generation spaces 401 in the state of FIG. 23B. Accordingly, by repeating the state of FIG. 23A and the state of FIG. 23B, the plasma generation spaces 401 and the exhaust spaces 402 are switched to each other at preset time intervals, so that the uniform supply of the gas mixture can be achieved on the average over time. Thus, it is possible to form a µc-Si film on the surface of the substrate S to have more uniform thickness and quality.

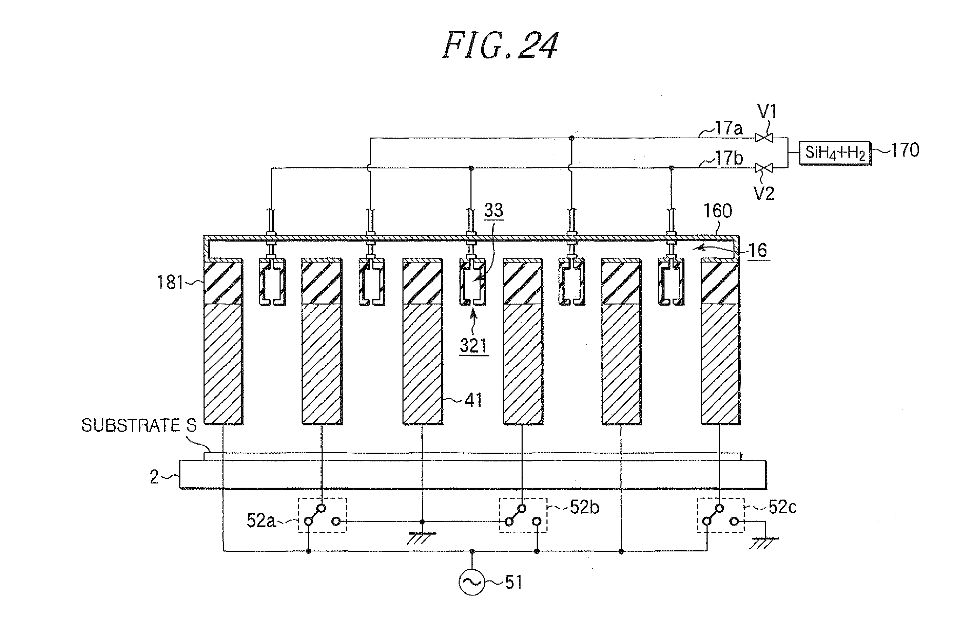

As described above, a method of switching the plasma generation spaces 401 and the exhaust spaces 402 over time may be applied to another case without being limited to the example in which H₂ is supplied from the first gas flow paths 33 to the upper portions of the plasma generation spaces 401 and SiH₄ is supplied from the second gas flow paths 411 to the lower portions of the plasma generation spaces 401. For example, as shown in FIG. 24, a gaseous mixture of H₂ and SiH₄ may be supplied from gaseous mixture supply pipes 17a and 17b of two lines toward the first gas flow paths 33 provided in the top plate 181 while the second gas flow paths are not provided in the partitions 41. Also in this case, by switching of the switches 52a and 52b and the valves V1 and V2 provided in the gaseous mixture supply pipes 17a and 17b, in the same way as the example of FIGS. 23A and 23B, the spaces between the facing partitions 41 may be switched between the plasma generation spaces 401 and the exhaust spaces 402, thereby supplying the uniform gaseous mixture to the surface of the substrate S on the average over time.

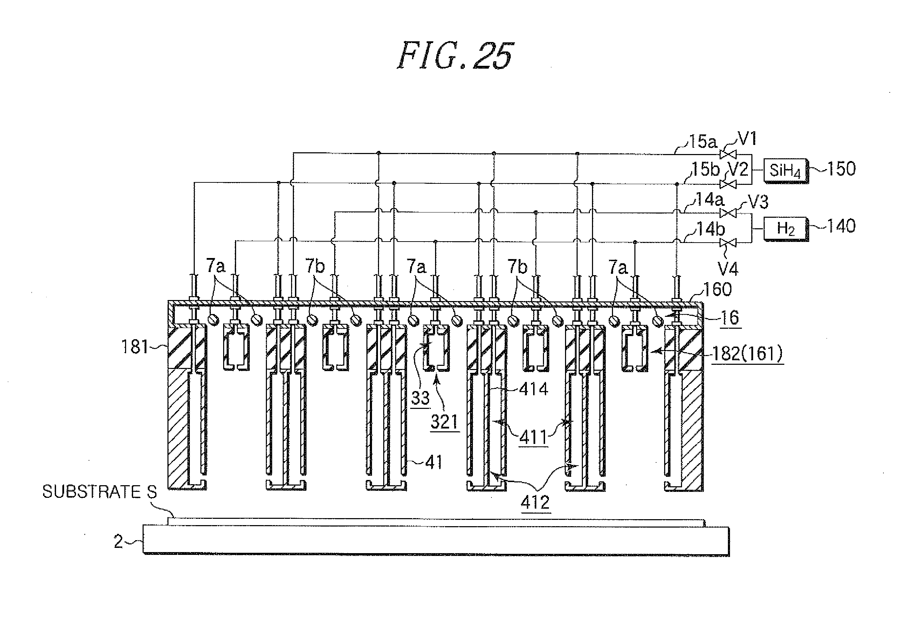

Further, a method of forming the plasma generation space 401 between the facing partitions 41 is not limited to a method in which one side of the partitions 41 is connected to the high frequency power supply unit 51 to serve as the cathode electrode 43 and the other side is grounded to serve as the anode electrode 42, thereby forming parallel electrodes. For example, as shown in FIG. 25, ICP antennas 7a and 7b may be arranged in, e.g., the gathering exhaust section 16 above the top plate 181. In this case, a power may be switchably supplied from the high frequency power supply unit 51 to the ICP antennas 7a and 7b by using, e.g., switches (not shown) serving as a connection switching unit. Further, H₂ and SiH₄ are supplied from the first gas flow paths 33 and the second gas flow paths 411 into regions in which an induction field is formed by the supply of power to the ICP antennas 7a and 7b, so that the regions serve as the plasma generation spaces 401. On the other hand, H₂ and SiH₄ are not supplied into regions below the ICP antennas 7a and 7b to which no power is supplied, so that the regions serve as the exhaust spaces 402. Further, by alternately forming the plasma generation spaces 401 and the exhaust spaces 402 over time, it is possible to perform the same operation as in the film formation apparatus 1e shown in FIGS. 23A and 23B.

Besides, an activating mechanism provided above the facing partitions 41 to form the plasma generation spaces 401 is not limited to a configuration including the ICP antennas 7a and 7b and the high frequency power supply unit 51. For example, columns of the microwave antenna units 6 are formed linearly along the spaces formed between the facing partitions 41. The microwave is switchably supplied from the microwave output unit 63 to each of the columns by, e.g., switches (not shown) (connection switching unit), so that the plasma generation spaces 401 and the exhaust spaces 402 can be replaced with each other.

In the above-described film formation apparatus 1e in which the plasma generation space 401 and the exhaust space 402 are alternately formed between two facing partitions 41 over time, the gathering exhaust section 16 is not limited to an example in which the gaseous mixture is exhausted toward a single cavity as shown in FIG. 21. For example, compartment walls may be provided in the gathering exhaust section 16 at positions corresponding to the partitions 41 to divide an inside of the gathering exhaust section 16. Further, exhaust positions of the gathering exhaust section 16 may be changed such that evacuation is stopped at positions of the gathering exhaust section 16 above the plasma generation spaces 401 and evacuation is performed only at positions from the exhaust spaces 402 toward the gathering exhaust section 16.

Further, evacuation of the gaseous mixture from the exhaust spaces 402 is not limited to a case where evacuation is performed from the upper side of the exhaust spaces 402 as shown in FIGS. 23A and 23B. For example, evacuation may be performed from the lateral side of the exhaust spaces 402 as in the example shown in FIG. 4.

Further, the partitions 41 forming parallel electrodes are not limited to a case where one side of the partitions 41 is connected to the high frequency power supply unit 51 and the other side of the partitions is grounded. For example, the parallel electrodes may be configured such that a high frequency power with an inverted phase with respect to a high frequency power applied to one side of the partitions 41 is applied to the other side of the partitions 41.

Further, although it is preferable that an execution time of the state shown in FIG. 23A (referred to as a first state) is equal to an execution time of the state shown in FIG. 23B (referred to as a second state), it is not a required condition. Even if the execution times of the first and second states are different, the supply deviation of the gaseous mixture can be reduced when considered on the average over time and the uniformity of film thickness and film quality can be improved compared to a case where the positions of the plasma generation spaces 401 and the exhaust spaces 402 are fixed.

In any of the above-described embodiments, the space above the substrate is divided in a transverse direction into the plasma generation spaces and the exhaust spaces by the partitions. A first reactant gas is activated in the plasma generation spaces to generate a plasma, while a second reactant gas is supplied to the lower portions of the plasma generation spaces or the side lower than the plasma generation spaces. Further, the gas on the substrate is exhausted from the exhaust spaces. Accordingly, the second reactant gas is reacted with active species generated from the first reactant gas while suppressing the promotion of decomposition due to contact with the plasma, so that desired film formation species can be present in high concentration in the vicinity of the substrate.

The film formation apparatuses 1a to 1e in accordance with the above-described embodiments, without being limited to a case of forming a µc-Si film on the substrate S, may be also applied to formation of an a-Si film by changing a supply ratio of SiH₄ to H₂, specifically, increasing a supply ratio of SiH₄.

Further, the present invention is not limited to a case where applied to film formation of a Si film using H₂ and SiH₄. For example, the present invention may be also applied to a case where a microcrystalline Si film is formed while H₂ serves as a first reactant gas and a silicon compound gas other than SiH₄, e.g., SiH₂Cl₂, serves as a second reactant gas.

## Claims

1. A film formation apparatus for forming a thin film on a substrate by reacting plural types of reactant gases in an airtight processing container, comprising:
a mounting table which is placed in the processing container and on which the substrate is mounted;
a partition which extends downward from a ceiling of the processing container and is provided to laterally divide a space above the substrate mounted on the mounting table into a plasma generation space and an exhaust space, an opening being formed between a bottom end of the partition and the substrate mounted on the mounting table to flow a gas from the plasma generation space to the exhaust space;
a first reactant gas supply section which supplies a first reactant gas to the plasma generation space;
an activating mechanism which activates the first reactant gas supplied to the plasma generation space to generate a plasma;
a second reactant gas supply section which supplies a second reactant gas to a lower portion of the plasma generation space or a side lower than the plasma generation space such that the second reactant gas reacts with active species of the first reactant gas to form the thin film on the substrate; and
a vacuum evacuation opening provided to evacuate the exhaust space.

2. The film formation apparatus of claim 1, wherein the vacuum evacuation opening is formed at a position higher than the bottom end of the partition.

3. The film formation apparatus of claim 1, wherein the activating mechanism includes:
an anode electrode and a cathode electrode forming parallel electrodes for generating a capacitively coupled plasma in the plasma generation space; and
a high frequency power supply unit which applies a high frequency power between the anode electrode and the cathode electrode.

4. The film formation apparatus of claim 1, wherein the activating mechanism includes an antenna provided above the plasma generation space to generate an inductively coupled plasma or a microwave plasma.

5. The film formation apparatus of claim 1, wherein the partition is provided in plural number, and the plural partitions are provided in parallel to each other, and
wherein plasma generation spaces and exhaust spaces are alternately arranged by the partitions.

6. The film formation apparatus of claim 5, wherein the partitions linearly extend in a lateral direction.

7. The film formation apparatus of claim 5, wherein the activating mechanism includes:
an anode electrode and a cathode electrode which are provided at one and the other of each of the pairs of partitions facing each other with the plasma generation spaces interposed therebetween, and form parallel electrodes for generating a capacitively coupled plasma; and
a high frequency power supply unit which applies a high frequency power between the anode electrode and the cathode electrode.

8. The film formation apparatus of claim 5, wherein the activating mechanism includes:
electrodes provided at the respective partitions, the electrodes provided at each pair of the partitions opposite to each other being a pair of parallel electrodes for generating a capacitively coupled plasma in a plasma generation space between the opposite partitions;
a high frequency power supply unit which applies a high frequency power between the pair of electrodes; and
a connection switching unit for switching connection between the electrodes forming the parallel electrodes and a power terminal of the high frequency power supply unit such that positions of the plasma generation space and the exhaust space are replaced with each other at preset time intervals.

9. The film formation apparatus of claim 8, further comprising a gas supply switching section for switching a gas supply in synchronization with a switching operation of the connection switching unit such that the first reactant gas and the second reactant gas are supplied to the plasma generation space and are not supplied to the exhaust space.

10. The film formation apparatus of claim 1, wherein the partition is formed in a cylindrical shape to surround the plasma generation space, and the partition having the cylindrical shape is provided in plural number to provide separated partitions, and
wherein the activating mechanism includes an antenna unit provided above each plasma generation space to generate an inductively coupled plasma or a microwave plasma.

11. The film formation apparatus of claim 1, wherein the vacuum evacuation opening is formed on a sidewall of the processing container.

12. The film formation apparatus of claim 1, wherein the first reactant gas is a hydrogen gas and the second reactant gas is a silicon compound gas.
